# EUROPÄISCHE PATENTSCHRIFT

(11) **EP 3 597 352 B1**
(45) Veröffentlichungstag und Bekanntmachung des Hinweises auf die Patenterteilung: **24.11.2021**
(21) Anmeldenummer: 19165685.9
(22) Anmeldetag: 28.03.2019
(51) Int. Cl.: B23K 26/00, B23K 26/0622, B23K 26/53, H01L 21/268, H01L 21/78, H01L 29/04, H01L 29/16, B23K 101/40, B23K 103/16, B23K 103/00

(54) **VERFAHREN ZUM ABTRENNEN VON FESTKÖRPERSCHICHTEN VON KOMPOSITSTRUKTUREN AUS SIC UND EINER METALLISCHEN BESCHICHTUNG ODER ELEKTRISCHEN BAUTEILEN**
METHOD OF SEPARATING SOLID BODY COATINGS OF COMPOSITE STRUCTURES MADE OF SIC AND A METALLIC COATING OR ELECTRICAL COMPONENTS
PROCÉDÉ DE SÉPARATION DE COUCHES DE CORPS SOLIDE DE STRUCTURES COMPOSITES À PARTIR DE SIC ET D'UN REVÊTEMENT MÉTALLIQUE OU DE COMPOSANTS ÉLECTRIQUES

(30) Priorität: 04.05.2018 DE 102018003675
(43) Veröffentlichungstag der Anmeldung: 22.01.2020
(73) Patentinhaber: Siltectra GmbH, 01099 Dresden (DE)
(72) Erfinder: RICHTER, Jan, 01277 Dresden (DE); SWOBODA, Marko, 01097 Dresden (DE)
(74) Vertreter: Müller Hoffmann & Partner

(56) Entgegenhaltungen:
- DE-A1-102014 218 759
- JP-A- 2016 164 908
- JP-A- 2016 215 231

## Beschreibung

Die vorliegende Erfindung bezieht sich gemäß der Ansprüche 1 und 14 jeweils auf Verfahren zum Erzeugen von Mikrorissen im Inneren einer Kompositstruktur bzw. von Modifikationen im Inneren eines Festkörpers und gemäß Anspruch 15 auf ein Verfahren zum Abtrennen von mindestens einer Festkörperschicht von einem Festkörper.

### Zum Stand der Technik

Die Druckschrift DE 10 2014 218 759 A1 (Basis für den Oberbegriff der Ansprüche 1 und 14) beschreibt ein Verfahren zum Bearbeiten eines Werkstücks, bei dem zunächst mittels eines ersten Laserstrahls, für dessen Wellenlänge das Werkstück ausreichend transparent ist, innerhalb des Werkstücks modifizierte Schichten ausgebildet werden. Mittels eines zweiten Laserstrahls mit einer Wellenlänge nahe der optischen Absorptionskante des Werkstücks werden Bereiche des Werkstücks um die modifizierten Schichten herum erwärmt. Die erwärmten Bereiche dehnen sich aus und es bilden sich jeweils ausgehend von den modifizierten Schichten Risse, die sich in Richtung einer Rückseitenoberfläche des Werkstücks ausdehnen und so das Werkstück senkrecht zur Rückseitenoberfläche teilen. Die Druckschrift DE102017206178A1 offenbart ein Waferherstellungsverfahren mit einem Herstellen eines Wafers aus einem zylindrischen SiC-Einkristallingot, der eine zylindrische Umfangsfläche mit einer ersten Ausrichtungsebene und einer zweiten Ausrichtungsebene, die kürzer als die erste Ausrichtungsebene und senkrecht zu der ersten Ausrichtungsebene ist, aufweist und einer kreisförmigen oberen Fläche, wobei der zylindrische SiC-Einkristallingot eine c-Achse, die von einer vertikalen Achse senkrecht zu der kreisförmigen oberen Fläche in Richtung der zweiten Ausrichtungsebene geneigt ist, und einen Abweichungswinkel aufweist, der zwischen einer c-Ebene senkrecht zu der c-Achse und der oberen Fläche ausgebildet ist, wobei das Waferherstellungsverfahren umfasst: einen Erfassungsschritt für eine Bearbeitungszuführrichtung mit einem Bestätigen, ob eine Richtung, in der die c-Achse geneigt ist, und die zweite Ausrichtungsebene senkrecht zueinander sind oder nicht und einem Erfassen einer Bearbeitungszuführrichtung senkrecht zu der Richtung, in der die c-Achse geneigt ist; einen Ausbildungsschritt für einen Bereich reduzierter Festigkeit mit einem Positionieren des Brennpunkts eines Laserstrahls von der kreisförmigen oberen Fläche aus in einer Tiefe in dem zylindrischen SiC-Einkristallingot, wobei die Tiefe der Dicke eines herzustellenden Wafers entspricht, und während eines relativen Bewegens des zylindrischen SiC-Einkristallingots und des Brennpunkts in der Bearbeitungszuführrichtung, die bei dem Erfassungsschritt für eine Bearbeitungszuführrichtung erfasst worden ist, Bestrahlen des zylindrischen SiC-Einkristallingots mit einem Laserstrahl, der eine Wellenlänge aufweist, die SiC überträgt, um dadurch einen geraden Bereich reduzierter Festigkeit auszubilden, der aus einer modifizierten Schicht parallel zu der kreisförmigen oberen Fläche und Rissen aufgebaut ist, die sich von der modifizierten Schicht in einer Tiefe entlang der c-Ebene erstrecken, die der Dicke des herzustellenden Wafers entspricht; die der Dicke des herzustellenden Wafers entspricht; einen Abziehebenenausbildungsschritt mit einem Ausbilden einer Abziehebene in dem zylindrischen SiC-Einkristallingot durch mehrmaliges Ausführen des Ausbildungsschritts für einen Bereich reduzierter Festigkeit mit vorbestimmten Abständen in einer Richtung senkrecht zu der Bearbeitungszuführrichtung; und nach dem Abziehebenenausbildungsschritt einen Waferherstellungsschritt mit einem Herstellen eines Wafers aus dem zylindrischen SiC-Einkristallingot durch Abziehen eines Abschnitts des zylindrischen SiC-Einkristallingots von der Abziehebene, die als Grenzfläche dient; wobei der Erfassungsschritt für eine Bearbeitungszuführrichtung einschließt: einen Abtastschritt mit einem Ausführen einer Abtastbestrahlung zum Positionieren des Brennpunkts eines Laserstrahls von der kreisförmigen oberen Fläche aus in einer vorbestimmten Tiefe in dem zylindrischen SiC-Einkristallingot und bei einem Bewegen des zylindrischen SiC-Einkristallingots und des Brennpunkts relativ zueinander, Bestrahlen des zylindrischen SiC-Einkristallingots mit einem Laserstrahl, der eine Wellenlänge aufweist, die SiC überträgt, entlang einer Richtung parallel zu der zweiten Ausrichtungsebene und einer Vielzahl von Richtungen, die im Uhrzeigersinn und gegen den Uhrzeigersinn durch jeweilige vorbestimmte Winkel von der zweiten Ausrichtungsebene aus geneigt sind, um dadurch in dem zylindrischen SiC-Einkristallingot eine Vielzahl abgetasteter gerader Bereiche reduzierter Festigkeit auszubilden, wobei jeder der abgetasteten geraden Bereiche reduzierter Festigkeit aus einer modifizierten Schicht parallel zu der kreisförmigen oberen Fläche und Rissen aufgebaut ist, die sich von der modifizierten Schicht entlang der c-Ebene erstrecken, und einen Bestimmungsschritt mit einem Aufnehmen jeweiliger Bilder der abgetasteten geraden Bereiche reduzierter Festigkeit mit einem Abbildungsmittel, Messen der Knotenanzahl, die pro Längeneinheit bei jedem der abgetasteten geraden Bereiche reduzierter Festigkeit in einem ihrer Bilder vorliegt, und Bestimmen einer Richtung, in welcher sich der abgetastete gerade Bereich reduzierter Festigkeit, wo die gemessene Knotenanzahl null ist, als Bearbeitungszuführrichtung erstreckt.

Es wurde erkannt, dass bei der Laservorschädigung Pulsenergie zum Teil in darunterliegende Materialbereiche transmittiert wird. Es gibt jedoch Fälle, in denen diese Bereiche jedoch der Laserstrahlung nicht ausgesetzt werden dürfen bzw. nur begrenz ausgesetzt werden dürfen.

Konkret kann es durch transmittierte Strahlungsenergie auf elektronischen Bauelementen zu Schädigungen kommen, weil bei diesen vor allem die metallischen Komponenten die Laserstrahlung zu großen Teilen aufnehmen. Dies führt zu Schädigungen der metallischen Strukturen selbst, als auch zu Schädigungen von Zwischenschichten, wie zum Beispiel bei Schottky Dioden, bei denen die Zwischenschicht von Metall und Halbleiter den gewünschten Diodeneffekt erzeugt. Eine Veränderung der Zwischenschicht durch Laserenergie führt dabei zum Bauteilausfall.

Dieses Problem tritt auf, wenn von einem sogenannten Devicewafer, einem Wafer mit fertigen bzw. halbfertigen elektronischen Bauelementestrukturen, der nicht benötigte untere Teil abgetrennt werden soll. Dies spart zum einem Schleifkosten, was insbesondere bei sehr harten Materialien, wie SiC, wirtschaftlich sehr relevant ist.

### Aufgabe der vorliegenden Erfindung

Es ist somit die Aufgabe der vorliegenden Erfindung ein Verfahren bereitzustellen, dass die Erzeugung einer sehr dünnen Kompositstruktur durch Abspalten von SiC-Festkörperanteilen bzw. einer Festkörperschicht, insbesondere SiC-Schicht, von der Kompositstruktur ermöglicht, wobei die Kompositstruktur zumindest eine Metallschicht und/oder elektrische Bauteile aufweisen soll.

### Beschreibung der Erfindung

Die zuvor genannte Aufgabe wird erfindungsgemäß durch ein Verfahren zum Erzeugen von Mikrorissen im Inneren einer Kompositstruktur gemäß Anspruch 1 gelöst. Das erfindungsgemäße Verfahren umfasst dabei mindestens die Schritte: Bereitstellen oder Erzeugen der Kompositstruktur, wobei die Kompositstruktur einen Festkörper und zumindest eine einerseits des Festkörpers angeordnete oder ausgebildete metallische Beschichtung und/oder elektrische Bauteile aufweist und andererseits eine ebene Oberfläche ausbildet, wobei der Festkörper Siliziumcarbid (SiC) aufweist oder daraus besteht. Erzeugen von Modifikationen im Inneren des Festkörpers, wobei Laserstrahlung über die ebene Oberfläche in den Festkörper eingebracht wird, wobei die Laserstrahlung eine Mehrphotonenanregung bewirkt, wobei die Mehrphotonenanregung eine Plasmaerzeugung bewirkt, wobei die Modifikation durch das Plasma in Form einer Materialumwandlung bewirkt wird, wobei die Materialumwandungen Druckspannungen im Festkörper erzeugen, wobei der Festkörper in einem umliegenden Bereich der jeweiligen Modifikation unterkritisch einreißt. Die Modifikationen werden dabei in einem Abstand von weniger als 150 µm zur metallische Beschichtung und/oder den elektrischen Bauteilen erzeugt. Die Laserstrahlung wird in Pulsen in den Festkörper eingebracht, wobei die Pulsintensität eines Pulses besonders innerhalb von 10ns, insbesondere innerhalb von 8ns oder 6ns oder 5ns oder 4ns oder 3ns oder 2ns oder 1,5ns oder 1ns, ab dem Beginn des jeweiligen Pulses die maximale Pulsintensität erreicht. Der Beginn des Pulses ist definiert als das Überschreiten von 1% der höchsten Pulsintensität. Als Ende des Pulses ist bevorzugt das Unterschreiten von 1% der höchsten Pulsintensität definiert, soweit nach dem Beginn des Pulses und vor dem Unterschreiten von 1% der höchsten Pulsintensität die maximale Pulsintensität erreicht wurde. Die Pulsdauer ist somit die Zeit zwischen Pulsbeginn und Pulsende.

Diese Lösung ist vorteilhaft, bei einer hohen Pulsintensität die Plasmaerzeugung schnell startet, wodurch die Transmission der Laserstrahlung zur Metallschicht bzw. den elektrischen Bauteilen begrenzt bzw. verhindert wird. Somit gelangt weniger Strahlung zur Metallschicht bzw. den elektrischen Bauteilen und somit weniger Energie, wodurch selbst bei einem Abstand von weniger als 150 µm zur metallische Beschichtung und/oder den elektrischen Bauteilen eine Beschädigung der metallischen Beschichtung und/oder der elektrischen Bauteile vermieden wird.

Die Lösung ist ferner vorteilhaft, da erstmals eine sehr präzise Energieverteilung über einen einzelnen Laserpuls vorgegeben wird.

Weiterhin ist vorteilhaft an der vorliegenden Lösung, dass aufgrund der rissbasierten Abtrennung des Festkörperanteils, dieser ein weiteres Mal als Devicewafer verwendet werden kann. Dies führt zu signifikanten Produktivitätsgewinnen. Zum einen wird gegenüber einer Dickereduzierung mittels Schleifen deutlich weniger Werkzeugverschleiß bewirkt. Zum anderen wird der abzutrennende Festkörperanteil nicht in Späne überführt, sondern kann ebenfalls als Festkörperschicht bzw. Wafer verwendet werden.

Die Metallschicht kann hierbei sowohl im Wesentlichen bzw. vollständig vollflächig ausgeführt sein, als auch als metallische Leiterbahnen mit einer Dicke von wenigen µm, insbesondere 1 µm bis 100 µm, insbesondere 1 µm bis 10 µm, bis wenige nm, insbesondere 1nm bis 100nm, insbesondere 1nm bis 10nm, ausgeführt sein.

Grundsätzlich wird bei der erfindungsgemäßen Laserbehandlung des Festkörpers eine Bündelung des Lichtes in einem Fokus bewirkt, wodurch mittels einer Multiphotonenabsorption freie Ladungsträger erzeugt werden. Hieraus resultiert eine Freisetzung von Elektronen, die freie Ladungsträger darstellen. Die bereits vorhandenen freien Ladungsträger absorbieren dadurch mehr Laserenergie, die Energie wird an das Festkörpermaterial abgegeben, wodurch wiederum mehr Elektronen freigesetzt werden bei weiterhin gleichzeitig erfolgender Multiphotonenabsorption. Dies führt dann zu einer Lawine von schnell ansteigender Elektronendichte, wodurch ein Elektronenplasma gezündet wird, was wiederum eine hohe Temperatur schafft, die wiederum eine Phasenumwandlung von SiC in amorphe Bestandteile bewirkt. SiC wird somit in Si und C umgewandelt. Wesentlich ist hierbei, dass nach dem Zünden des Elektronenplasmas die Transmission der Laserstrahlung sehr stark unterdrückt wird. Dies erfolgt durch Absorption der freien Elektronen im Plasma und/oder Reflektion und Streuung der Strahlung durch das Plasma.

Beim Zünden des Plasmas handelt es sich um einen Schwellprozess, bei dem zum Ingangsetzen der Elektronenlawine eine kritische Intensität für einen Multiphotonenprozess erreicht werden muss und darauf eine Energie größer als eine Schwellenergie im Fokuspunkt deponiert werden muss, bevor die Elektronenlawine zum Zünden des Plasmas führt. Daher bewirkt die erfindungsgemäße Lösung, dass der Laserpuls eine sehr steile Anfangsflanke aufweist, sodass die Intensitätsschwelle möglichst schnell überschritten wird und das Plasma schnellstmöglich zündet.

Unterkritisch bedeutet hierbei, dass die Rissausbreitung zum Erliegen kommt bzw. stoppt bevor der Riss den Festkörper in mindestens zwei Teile teilt. Bevorzugt breitet sich ein unterkritischer Riss weniger als 5mm, insbesondere weniger als 1mm oder weniger als 500µm oder weniger als 250µm oder weniger als 100µm, in dem Festkörper aus. Die Modifikationen werden bevorzugt derart erzeugt, dass sich z.B. beim Abtrennen von ebenen Festkörperplatten die unterkritischen Risse bevorzugt mehrheitlich in derselben Ebene ausbreiten, insbesondere in einer zur Oberfläche des Festkörpers, durch welche die Laserstrahlen in den Festkörper eindringen, parallelen oder definiert ausgerichteten Ebene ausbreiten. Die Modifikationen werden bevorzugt derart erzeugt, dass sich z.B. beim Abtrennen von unebenen Festkörpern die unterkritischen Risse bevorzugt derart definiert, z.B. in einer sphärischen Lage bzw. Schicht ausbreiten, dass der Ablösebereich eine definierte, insbesondere sphärische, Form erhält.

Weitere bevorzugte Ausführungsformen sind Gegenstand der Unteransprüche und der nachfolgenden Beschreibungsteile.

Gemäß einer bevorzugten Ausführungsform der vorliegenden Erfindung bringt jeder Puls eine Energie E in den Festkörper ein, wobei durch die Plasmaerzeugung und/oder bereits erzeugte Mikrorisse maximal 20%, insbesondere maximal 15% oder maximal 10% oder maximal 5% oder maximal 1% oder maximal 0,5%, der Energie E des jeweiligen Pulses bis zur metallischen Beschichtung und/oder den elektrischen Bauteilen durch den Festkörper transmittiert wird. Diese Ausführungsform ist vorteilhaft, da eine Begrenzung des maximalen Energieeintrags pro Puls auf die Metallschicht bzw. metallische Struktur bzw. elektrischen Bauteile erfolgt, wodurch eine Beschädigung der Metallschicht bzw. metallische Struktur bzw. elektrischen Bauteile infolge der Transmission der Laserstrahlung verhindert wird. Das elektrische Bauteil kann z.B. eine Schottky Diode sein bzw. die Kompositstruktur kann eine Vielzahl an Schottky Dioden oder Bauteile oder Anteile davon aufweisen.

Das Plasma wird gemäß einer weiteren bevorzugten Ausführungsform der vorliegenden Erfindung je Puls innerhalb einer Zeit x ab dem Beginn des Pulses erzeugt. Bevorzugt ist hierbei x kürzer als die Pulsdauer y. Besonders bevorzugt ist x kleiner als 10ns, insbesondere kleiner als 7,5ns oder kleiner als 5ns oder kleiner als 3ns oder kleiner als 2ns oder kleiner als 1ns oder kleiner als 0,75ns oder kleiner als 0,5ns. Zusätzlich oder alternativ ist kann gelten x<0,5*y, insbesondere x<0,2*y oder x<0,1*y oder x<0,05*y oder x<0,01*y, gilt. Diese Ausführungsform ist vorteilhaft, da die frühzeitige Erzeugung des Plasmas einen Schutz der Metallschicht bzw. metallische Struktur bzw. elektrischen Bauteile bewirkt.

Die Strahlqualität (M²) ist gemäß einer weiteren bevorzugten Ausführungsform der vorliegenden Erfindung kleiner als 1,4, insbesondere kleiner als 1,3 oder kleiner als 1,2 oder kleiner 1,1. Diese Ausführungsform ist ebenfalls vorteilhaft, da dadurch die Mehrphotonenanregung und somit die Plasmaerzeugung sehr genau kontrollierbar ist.

Die Laserstrahlung wird gemäß einer weiteren bevorzugten Ausführungsform der vorliegenden Erfindung mit einer Pulsdauer von weniger als 9ns, insbesondere von weniger als 8ns oder weniger als 7ns oder weniger als 6ns oder weniger als 5ns oder weniger als 4ns oder weniger als 3ns oder weniger als 2ns oder weniger als 1,8ns oder weniger als 1,6ns oder weniger als 1,4ns oder weniger als 1,1ns oder weniger als 0,9ns oder weniger als 0,75ns oder weniger als 0,6ns oder weniger als 0,5ns oder weniger als 0,4ns, erzeugt.

Gemäß einer weiteren bevorzugten Ausführungsform der vorliegenden Erfindung ist bei einer Pulsdauer zwischen 0,9ns und 10ns eine Flächenenergie von 10 - 200 nJ/µm² vorgesehen oder bei einer Pulsdauer zwischen 10ps und 1,1ns ist eine Flächenenergie von 0,1-50 nJ/µm² vorgesehen oder bei einer Pulsdauer zwischen 100fs und 11ps ist eine Flächenenergie von 0,01-0,1 nJ/µm² vorgesehen.

Die Strahlungsintensität eines Pulses weist gemäß einer weiteren bevorzugten Ausführungsform der vorliegenden Erfindung nach dem Erreichen des Maximums für eine Mindestdauer von 10ps, insbesondere von mindesten 50ps oder mindestens 100ps oder 500ps oder 1ns, insbesondere zum Erzeugen eines thermischen Prozesses, und einer Maximaldauer von 25ns, insbesondere von 15ns oder 10ns oder 7,5ns oder 5ns oder 3,5ns oder 2,5ns oder 2ns, über 50% der Strahlungsintensität auf. Diese Ausführungsform ist vorteilhaft, da ausreichend viel Zeit zur thermischen Behandlung, insbesondere Erzeugung der Modifikation, besteht.

Die Laserstrahlung ist gemäß einer weiteren bevorzugten Ausführungsform der vorliegenden Erfindung definiert, insbesondere linear, polarisiert. Die Polarisationsrichtung der Laserstrahlung ist dabei bevorzugt in einem definierten Winkel, insbesondere festem Winkel von 0° oder 90°, oder definierten Winkelbereich, insbesondere -20° bis 20° oder -10° bis 10° oder -5° bis 5° oder -1° bis 1° oder 70° bis 110° oder 80° bis 100° oder 85° bis 95° oder 89° bis 91° oder in einem Winkel <30° oder in einem Winkel <20° oder in einem Winkel <15° oder in einem Winkel <10° oder in einem Winkel <5°, gegenüber der Kristallachse des Festkörpers orientiert.

Bei einer Polarisation des Lasers parallel zum Hauptflat wurde bei Laserbearbeitung in die C-Seite des SiC-Substrats festgestellt, dass es einer um ca. 50% höhere Laserenergie bedarf, um vergleichbare Schadmuster auszubilden, gegenüber einer Laserpolarisation senkrecht zum Hauptflat in dieser Konfiguration. Wird zirkular polarisiertes Licht verwendet, so wird bei einem Polarisator entgegen der Durchlasspolarisation eine um 1/3 verminderte transmittierte Laserleistung gemessen. Dies bedeutet, dass für zirkular polarisiertes Licht die genutzte Laserenergie gegenüber der linearen Idealpolarisation wahrscheinlich um einen Betrag von bis zu 50% erhöht werden muss. Insbesondere durch die Nichtlinearität des Prozesses und der Wirkungsquerschnitte für Multiphotoneneffekte in SiC für zirkular polarisiertes Licht kann dieser Unterschied jedoch auch geringer sein. Ein Wert zwischen den Schwellenergien für ideale und dazu um 90° gedrehter Laserpolarisation ist dementsprechend auch möglich, da im Zuge der rotierenden Laserpolarisation beide Polarisationen transient überstrichen werden. Multiphotoneneffekte haben jedoch meist bessere Wirkungsquerschnitte für linear polarisiertes Licht, sodass für perfekt zirkular polarisiertes Licht noch größere Energien aufgewandt werden müssen.

Die Laserstrahlung ist gemäß einer weiteren bevorzugten Ausführungsform der vorliegenden Erfindung elliptisch polarisiert oder zirkular polarisiert. Diese Ausführungsform ist vorteilhaft, da durch eine definierte Polarisation der Laserstrahlung Modifikationen erzeugt werden können, die eine sehr kurze, insbesondere kürzer als 100 µm, Rissausbreitung der unterkritischen Risse ermöglicht.

Die Längserstreckungsrichtung der mittels der Laserstrahlen im Inneren des Festkörpers erzeugten Modifikationen in einem definierten Winkel, insbesondere festem Winkel von 0° oder 90°, oder definierten Winkelbereich, insbesondere -20° bis 20° oder -10° bis 10° oder -5° bis 5° oder -1° bis 1° oder 70° bis 110° oder 80° bis 100° oder 85° bis 95° oder 89° bis 91°, gegenüber einer sich an der, insbesondere gedachten oder virtuellen, Schnittstelle zwischen einer Ebene auf der die Modifikationen erzeugt werden (Erzeugungsebene) und einer Kristallgitterebene ergebenden, insbesondere virtuellen bzw. gedachten, Schnittlinie ausgerichtet ist.

Die mittlere Risslänge wird hierbei bevorzugt in einer Ebene bestimmt, d.h. die Rissausbreitung in orthogonaler Richtung zur Längserstreckungsrichtung der linienförmigen Gestalt wird in derselben Ebene einerseits und andererseits der linienförmigen Gestalt erfasst und bevorzugt modifikationsaufgelöst ausgewertet bzw. bestimmt.

Der Festkörper kann hierbei Siliziumkarbid aufweisen oder aus Siliziumkarbid (SiC), insbesondere aus dotiertem Siliziumkarbid, bestehen.

Die Laserstrahlung wird gemäß einer weiteren bevorzugten Ausführungsform der vorliegenden Erfindung über mindestens ein optisches Element in den Festkörper eingebracht, wobei das optische Element, insbesondere eine Linse, eine Numerische Apertur (NA) von mehr als 0,4, insbesondere von mehr als 0,5 oder 0,6 oder 0,7 oder 0,8 oder 0,9, aufweist. Zusätzlich oder alternativ kann die Laserstrahlung vor dem Eindringen in den Festkörper bevorzugt durch eine Immersionsflüssigkeit, insbesondere eine Immersionslösung, geleitet werden, wobei die NA bei Verwendung einer Immersionsflüssigkeit bevorzugt größer 1, insbesondere größer 1,1 oder 1,2 oder 1,3 und bevorzugt bis zu 2, ist.

Die einzelnen Modifikationen weisen gemäß einer weiteren bevorzugten Ausführungsform der vorliegenden Erfindung eine maximale Erstreckung in Festkörperlängsrichtung (Z) auf, wobei die maximale Erstreckung der Modifikationen bevorzugt jeweils kleiner als 100µm, insbesondere weniger als 80µm oder weniger als 70µm oder weniger als 6ßµm oder weniger als 50µm oder weniger als 40µm oder weniger als 30µm oder weniger als 20µm oder weniger als 15µm oder weniger als 10µm oder weniger als 8µm oder weniger als 6µm oder weniger als 5µm oder weniger als 4µm oder weniger als 3µm oder weniger als 2µm oder weniger als 1µm oder weniger als 0,5µm, ist. In Festkörperlängserstreckungsrichtung sind die erste Oberfläche, über welche die Laserstrahlen in den Festkörper eindringen, und die zweite Oberfläche des Festkörpers, an der die Metallschicht/en und/oder die elektrischen Bauteile angeordnet bzw. ausgebildet sind, voneinander beabstandet.

Eine Vielzahl an Modifikationen werden gemäß einer weiteren bevorzugten Ausführungsform der vorliegenden Erfindung unter Ausbildung einer linienförmigen Gestalt oder mehrerer linienförmiger Gestalten, insbesondere einer Schreiblinie oder mehrerer Schreiblinien, erzeugt. Die unterkritischen Risse weisen dabei orthogonal zur Längserstreckungsrichtung der jeweiligen linienförmigen Gestalt eine mittlere Risslänge von weniger als 150 µm, insbesondere von weniger als 120 µm oder weniger als 110 µm oder weniger als 90 µm oder weniger als 75 µm oder weniger als 60 µm oder weniger als 50 µm oder weniger als 40 µm oder weniger als 30µm oder weniger als 25µm, auf.

Gemäß einer weiteren bevorzugten Ausführungsform der vorliegenden Erfindung werden Modifikationen, die zur selben linienförmigen Gestalt gehören und nacheinander erzeugt werden, in einem Abstand zueinander erzeugt, der durch die Funktion (d-x)/d<-0,31, insbesondere <-0,4, definiert wird, wobei hierbei x>d gilt. Diese Ausführungsform ist vorteilhaft, da durch die angegebene Bedingung (d-x)/d<-0,31 definiert wird, dass die Fokuspunkte der nacheinander erzeugten Modifikationen derselben linienförmigen Gestalt so weit voneinander beabstandet sind, dass die zuvor erzeugte Materialumwandung bei der danach erfolgenden Materialumwandung keine oder nur geringe Effekte, insbesondere keine oder nur gering erhöhte Absorption, bewirkt. Dies ist vorteilhaft, da die Modifikationen dadurch sehr präzise erzeugt werden können, wodurch die Neigung von unterkritischen Rissen sich stärker auszubreiten besser kontrolliert werden kann.

Der Abstand zwischen jeweils zwei unmittelbar nebeneinanderliegenden linienförmigen Gestalten beträgt gemäß einer weiteren bevorzugten Ausführungsform der vorliegenden Erfindung weniger als 400µm, insbesondere weniger als 300µm oder weniger als 250µm oder weniger als 200µm oder weniger als 150µm oder weniger als 100µm oder weniger als 75µm oder weniger als 50µm oder weniger als 40µm oder weniger als 30µm oder weniger als 25µm oder weniger als 20µm oder weniger als 15µm oder weniger als 10µm.

Diese Ausführungsform ist vorteilhaft, da eine Rissfront geschaffen wird, welche der freigelegten Oberfläche des verbleibenden Restfestkörpers und der freigelegten Oberfläche der abgetrennten Festkörperschicht eine charakteristische Gestalt aufprägt. Diese charakteristische Gestalt bildet auf Seiten der Festkörperschicht und/oder auf Seiten des Restfestkörpers bevorzugt zick-zack-förmige Erhebungen und/oder Täler aus. Dies gilt für alle Festkörper, deren Kristallebenen und/oder Gleitebenen, d.h. bevorzugte Rissebenen, gegenüber der ersten Oberfläche, durch die die Laserstrahlung in den Festkörper eingebracht wird, geneigt sind.

Die in dem Festkörper erzeugten Modifikationen werden gemäß einer weiteren bevorzugten Ausführungsform der vorliegenden Erfindung zu einem ersten Teil während einer ersten Relativbewegung des Festkörpers gegenüber einer Optik des Lasers erzeugt und zu einem zweiten Teil während einer zweiten Relativbewegung des Festkörpers gegenüber der Optik des Lasers erzeugt werden. Die erste Relativbewegung ist dabei bevorzugt eine geradlinige Bewegung in einer ersten Richtung und die zweite Relativbewegung ist dabei bevorzugt eine geradlinige Bewegung in einer zweiten Richtung, wobei die Überfahrwege bevorzugt parallel zueinander sind. Bevorzugt bildet der gesamte Verfahrweg eine Mäanderform aus oder eine durch einen X-Y-Tisch bewirkte Verfahrbewegung.

Im Weg der Laserstrahlung ist gemäß einer weiteren bevorzugten Ausführungsform der vorliegenden Erfindung vor dem Eindringen der Laserstrahlung in das Spendersubstrat bzw. in den Festkörper ein diffraktives optisches Element (DOE) angeordnet. Die Laserstrahlung wird durch das DOE auf mehrere Lichtpfade zum Erzeugen mehrerer Fokusse aufgeteilt. Das DOE bewirkt bevorzugt über eine Länge von 200µm eine Bildfeldwölbung, die kleiner oder gleich 50µm, insbesondere kleiner oder gleich 30µm oder kleiner oder gleich 10µm oder kleiner oder gleich 5 µm oder kleiner oder gleich 3µm, ist, wobei durch das DOE zumindest 2 und bevorzugt mindestens oder genau 3 oder mindestens oder genau 4 oder mindestens oder genau 5 oder mindestens oder genau oder bis zu 10 oder mindestens oder genau oder bis zu 20 oder mindestens oder genau oder bis zu 50 oder bis zu 100 Fokusse zur Veränderung der Materialeigenschaften des Spendersubstrats zeitgleich erzeugt werden. Diese Ausführungsform ist vorteilhaft, da eine signifikante Prozessbeschleunigung erzielt werden kann.

Es wurde somit im Rahmen der vorliegenden Erfindung erkannt, dass hohe Leistungen mit diffraktiven optischen Elementen (DOEs) auf mehrere Foki in der Brennebene aufgeteilt werden. DOEs zeigen Interferenzerscheinungen schon vor der Brennebene, es wurde erkannt, dass Interferenzen an der Oberfläche, vor der Brennebene lokale Intensitätsmaxima erzeugen können, die zur Schädigung der Oberfläche führen können und zu einer verringerten Transmissivität für Laserstrahlung zur Bearbeitung in der Tiefe führen können. Weiterhin wurde erkannt, dass manche Materialien (Bsp: SiC) lokale Brechindex- und andere Materialeigenschaftsunterschiede (z.B. Absorption, Transmission, Streuung), z.B. durch die Materialdotierung (häufiges Auftreten: Dotierfleck) haben. Ferner wurde erkannt, dass abhängig von der Oberflächenrauhigkeit des Materials an der Lasereinkoppeloberfläche die Wellenfront des Lasers in der Tiefe des Materials signifikant beeinträchtigt werden kann, sodass der Fokus reduzierte Intensität aufweist (geringere Multiphotonenübergangswahrscheinlichkeit), was wieder höhere Intensitäten mit oben genannten Problemen nach sich ziehen würde.

Eine Einstrahlung der Laserstrahlen auf bzw. in den Festkörper bzw. das Spendersubstrat unter dem Brewster-Winkel ist kompliziert bzw. kann anspruchsvoll sein, da die unterschiedlichen Strahlanteile unterschiedlich lange Wege im hochbrechenderen Medium zurücklegen. Der Fokus muss dementsprechend durch höhere Energie angepasst werden und/oder durch Strahlformung. Die Strahlformung erfolgt hierbei bevorzugt z.B. über ein oder mehrere diffraktive optische Element/e (DOE), was diesen Unterschied abhängig über das Laserstrahlprofil ausgleicht. Der Brewster-Winkel ist relativ groß, was bei hoher numerischer Apertur Anforderungen an die Optik und deren Maße sowie Arbeitsabstand stellt. Dennoch ist diese Lösung vorteilhaft, da reduzierte Reflexionen an der Oberfläche auch zu reduzierter Oberflächenschädigung beitragen, da die Lichtintensität besser ins Material hineinkoppelt. Im Sinne dieser Erfindung können Laserstrahlen auch in allen anderen in dieser Schrift offenbarten Ausführungsformen im Brewster-Winkel oder im Wesentlichen im Brewster-Winkel eingestrahlt werden. Zur Brewster-Winkel-Einkopplung wird hiermit auf das Dokument "Optical Properties of Spin-Coated TiO2 Antireflection Films on Textured Single-Crystalline Silicon Substrates" (Hindawi Publishing Corporation International Journal of Photoenergy, Volume 2015, Article ID 147836, 8 pages, http://dx.doi.org/10.1155/2015/147836) verwiesen. Dieses Dokument wird durch Bezugnahme vollumfänglich zum Gegenstand der vorliegenden Patentanmeldung gemacht. Das zuvor genannte und einbezogene Dokument offenbart insbesondere Berechnungen zum optimalen Einstrahlwinkel für verschiedene Materialien und damit Brechindizes. Die Energie des Lasers bzw. der Laserbeaufschlagungseinrichtung wird nicht so sehr in Abhängigkeit vom Material, sondern eher von der möglichen Transmission unter einem bestimmten Winkel angepasst. Wenn also die optimale Transmission z.B. 93% beträgt, so müssen diese Verluste gegenüber Versuchen mit senkrechter Einstrahlung und Verlusten von z.B. dann 17% berücksichtigt werden und die Laserleistung dementsprechend angepasst werden.

Ein Beispiel: 83% Transmission senkrecht gegenüber 93% unter Winkel, bedeutet, dass zum Erzielen der gleichen Energie in der Tiefe, nur noch 89% der bei senkrechter Einstrahlung verwendeten Laserleistung benötigt werden (0.83/0.93=0.89). Im Sinne der Erfindung dient der Teil der schrägen Einstrahlung also bevorzugt dazu weniger Licht durch Oberflächenreflexion zu verlieren und mehr in die Tiefe zu bringen. Ein mögliches nachgelagertes Problem, das dadurch in bestimmten Konstellationen auftreten kann, ist, dass der Fokus in der Tiefe ein "schiefes" Profil erhalten kann und damit die erreichten Intensitäten - die Schlüsselgröße für Multiphotonenbearbeitung - wieder geringer sind, eventuell also sogar geringer als bei senkrechter Einstrahlung, wo alle Strahlanteile denselben optischen Weg im Material durchlaufen. Dies kann dann bevorzugt durch ein diffraktives optisches Element oder durch mehrere diffraktive Elemente oder einen durchlaufenden Keil oder mehrere durchlaufende Keile - und/oder andere optische Elemente - im Strahlengang geschehen, die diese zusätzlichen Wege und/oder den Einfluss auf die einzelnen Strahlen - insbesondere unterschiedliche sphärische Aberrationen über das Strahlprofil hin - kompensieren. Diese DOEs kann man numerisch mit geeigneten Softwarelösungen (z.B. Virtuallab von Lighttrans, Jena) berechnen und dann fertigen bzw. bereitstellen.

Gemäß einer weiteren bevorzugte Ausführungsform der vorliegenden Erfindung werden die nachfolgend genannten Parameter eingestellt: NA>0,6, Anstieg der Intensität von 1% bis Max. Intensität des Pulses schneller als 10ns, Abstand zwischen zwei linienförmigen Gestalten kleiner 100 µm, Strahlqualität kleiner 1,4, Schädigungstiefe (Abstand zur Metallschicht bzw. metallischen Struktur bzw. elektrischen Bauteilen) weniger als 115 µm, Punkt zu Punktabstand zweier benachbarter Modifikationen 5 µm, 1064nm Laser, Pulsenenergie zwischen 5 und 20 µJoule/Puls und Dotierung zwischen 10 und 50 Milliohm/cm. Es hat sich gezeigt, dass diese Einstellung bei SiC sehr vorteilhafte Ergebnisse liefert.

Die Kompositstruktur weist dabei mindestens einen Festkörper bzw. ein Spendersubstrat auf, wobei der Festkörper bzw. das Spendersubstrat SiC aufweist oder daraus besteht. Ferner weist die Kompositstruktur mindestens eine Metallschicht und/oder elektrischen Bauteile auf.

Diese Lösung ist vorteilhaft, da eine Kompositstruktur und eine Festkörperschicht erzeugt wird, deren Oberflächenstruktur das unkontrollierte Ausbreiten von Rissen reduziert bzw. verhindert.

Die zuvor genannte Aufgabe wird durch ein Verfahren zum Erzeugen von Modifikationen im Inneren eines Festkörpers gemäß dem Anspruch 14 gelöst, das mindestens die nachfolgend genannten Schritte aufweist: Einbringen von Laserstrahlung eines Lasers über eine erste Oberfläche des Festkörpers in das Innere des Festkörpers, wobei der Festkörper eine Kristallstruktur ausbildet und bevorzugt aus SiC besteht und wobei durch die Laserstrahlung Modifikationen an vorbestimmten Stellen auf einer Erzeugungsebene im Inneren des Festkörpers zum Vorgeben einer Ablöseebene erzeugt werden, wobei die Laserstrahlung je Modifikation das Konditionieren eines Plasmas zum Modifizieren des Festkörpers bewirkt, wobei das Plasma für eine Modifikationserzeugungszeit existent gehalten wird, wobei ab dem Beginn eines Laserpulses und bis unmittelbar vor der Konditionierung des Plasmas eine Transmissionszeit liegt, in der die Laserstrahlung zumindest teilweise durch den Festkörper hindurch läuft, wobei die Konditionierung des Plasmas in einer Plasmakonditionierungszeit erfolgt, wobei das Plasma beaufschlagende Laserstrahlung zumindest mehrheitlich und bevorzugt vollständig vom Plasma absorbiert und/oder reflektiert und/oder gestreut wird, wobei die Gesamtzeit aus Modifikationserzeugungszeit, Transmissionszeit und Plasmakonditionierungszeit, insbesondere Zündung und Aufheizung des Plasmas, mindestens 70% einer Pulsdauer der Laserstrahlung während der Erzeugung der Modifikation entspricht, wobei die Pulsdauer kleiner ist als 100ns ist, wobei die Laserstrahlung im Fokuspunkt eine definierte Strahlungsintensität erzeugt, durch die sich eine definierte Elektronendichte ergibt, wobei die Elektronendichte im Fokuspunkt innerhalb der Modifikationserzeugungszeit einen vordefinierten Schwellenwert überschreitet, wobei die Modifikationserzeugungszeit kürzer ist als 70ns. Die Modifikationserzeugungszeit kann hierbei bevorzugt kürzer als 4ns, insbesondere kürzer ist als 3ns oder 2ns oder 1ns, sein.

Weiterhin bezieht sich die vorliegende Erfindung auf ein Verfahren zum Abtrennen von mindestens einer Festkörperschicht von einem Festkörper. Das Verfahren umfasst dabei bevorzugt mindestens die Schritte: Durchführen eines hierin beschriebenen Verfahrens, Einleiten einer äußeren Kraft in den Festkörper zum Erzeugen von Spannungen in dem Festkörper und/oder Erzeugen einer inneren Kraft in dem Festkörper, wobei die äußere und/oder innere Kraft so stark ist, dass daraus eine Rissausbreitung bzw. Verbindung der unterkritischen Risse entlang des Ablösebereichs resultiert.

Weitere Vorteile, Ziele und Eigenschaften der vorliegenden Erfindung werden anhand nachfolgender Beschreibung anliegender Zeichnungen erläutert, in welchen beispielhaft das erfindungsgemäße Trennverfahren dargestellt ist. Bauteile oder Elemente, die in dem erfindungsgemäßen Verfahren bevorzugt eingesetzt werden und/oder welche in den Figuren wenigstens im Wesentlichen hinsichtlich ihrer Funktion übereinstimmen, können hierbei mit gleichen Bezugszeichen gekennzeichnet sein, wobei diese Bauteile oder Elemente nicht in allen Figuren beziffert oder erläutert sein müssen.

Darin zeigt:
- Fig. 1a: eine erste schematische Darstellung des Zusammenhangs zwischen Schreiblinie und polarisierter Laserstrahlung;
- Fig. 1b: eine zweite schematische Darstellung des Zusammenhangs zwischen Schreiblinie und polarisierter Laserstrahlung;
- Fig. 2a-e: verschiedene exemplarischer Darstellungen unterschiedlicher Polarisationen,
- Fig. 3a: eine dritte schematische Darstellung des Zusammenhangs zwischen Schreiblinie und polarisierter Laserstrahlung;
- Fig. 3b: eine vierte schematische Darstellung des Zusammenhangs zwischen Schreiblinie und polarisierter Laserstrahlung;
- Fig. 4a: ein Spendersubstrat mit gegenüber der Längsachse in einem Winkel von ungleich 90° ausgerichteten Kristallgitterebenen und erzeugten Laserschreiblinien,
- Fig. 4b: den aus Fig. 4a bekannten Festkörper ergänzt um eine Metallschicht und/oder elektrische Bauteile,
- Fig. 5: ein weiteres Spendersubstrat mit gegenüber der Längsachse in einem Winkel von ungleich 90° ausgerichteten Kristallgitterebenen und erzeugten Laserschreiblinien, wobei die Ausrichtung der Laserschreiblinien bzw. linienartigen Gestalt mittels Ebenen definiert ist,
- Fig. 6: dass die Modifikationen einer linienförmigen Gestalt eine Vielzahl unterschiedlicher Kristallgitterebenen schneiden,
- Fig. 7: ein Beispiel eines Kristallgitters mit Gleitebene für 4HSiC,
- Fig. 8a: ein Beispiel eines Kristallgitters mit Gleitebene 110 für Si,
- Fig. 8b: ein Beispiel eines Kristallgitters mit Gleitebene 100 für Si,
- Fig. 8c: ein Beispiel eines Kristallgitters mit Gleitebene 111 für Si,
- Fig. 9a: eine schematische Darstellung der theoretischen Zusammenhänge der Formel (d-x)/x;
- Fig. 9b: eine typische Oberflächenstruktur einer Festkörperoberfläche einer nach dem erfindungsgemäßen Verfahren abgetrennten Festkörperschicht,
- Fig. 9c: eine Darstellung von Schreiblinien, die infolge unterschiedlich definierter Parameter erzeugt wurden,
- Fig. 9d: verschiedene zick-zackförmige Linien,
- Fig. 10a-c: optische Mittel zur Veränderung der Laserstrahleigenschaften,
- Fig. 11: schematisch den Verlauf der Strahlungsintensität eines Laserpulses über die Zeit,
- Fig. 12: schematisch die Elektronendichte im Fokus während eines Laserpulses,
- Fig. 13: schematisch den Verlauf der Strahlungsintensität eines idealisierten Laserpulses, insbesondere eines Tophead-Profils, über die Zeit.

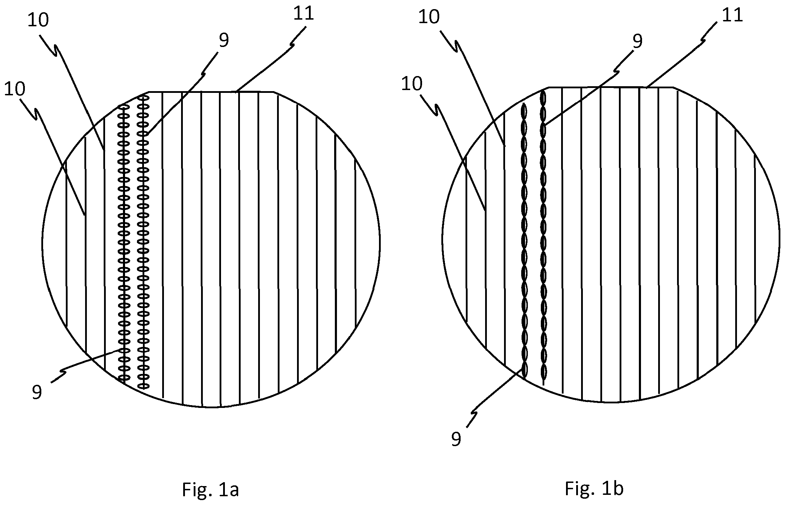

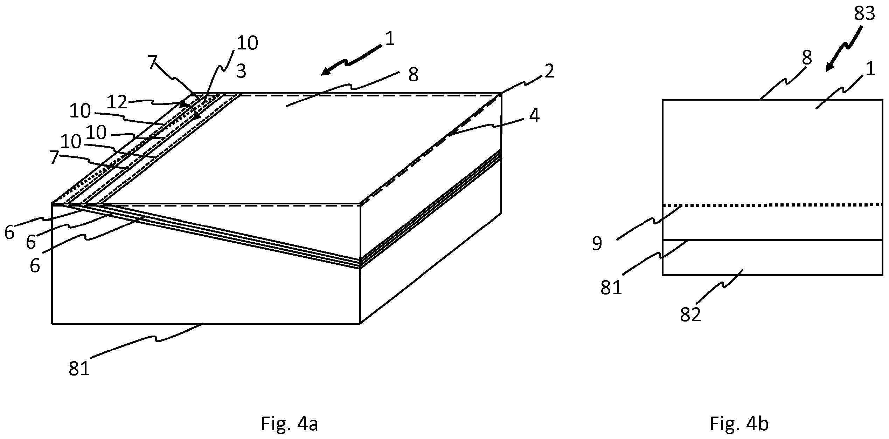

Fig. 1a zeigt eine schematische Darstellung eines Festkörpers 1 während einer Behandlung, insbesondere der Erzeugung von Modifikationen 9 im Inneren des Festkörpers 1. Die Modifikationen 9 stellen dabei bevorzugt mittels Mehrphotonenanregung erzeugte Phasenumwandlungen des Festkörpermaterials, insbesondere SiC, dar. Gemäß dieser Darstellung werden die Modifikationen 9 derart erzeugt, dass sie voneinander beabstandet sind. Diese Lösung ist vorteilhaft, da dadurch eine bereits erzeugte Modifikation 9 die Absorption der Laserstrahlen nicht oder nur unwesentlich stark verändert bzw. beeinflusst. Die Modifikationen 9 werden bevorzugt in Form von linienförmigen Gestalten bzw. Schreiblinien 103 erzeugt. Die Schreiblinien 103 sind dabei bevorzugt geradlinig ausgebildet. Die Schreiblinien 103 sind gemäß dieser Darstellung bevorzugt parallel zur Schnittlinie 10 orientiert. Die Schnittlinie 10 resultiert dabei bevorzugt aus einer Schnittstelle zwischen der Erzeugungsebene 4 und der Kristallgitterebene 6 (vgl. Fig. 4a). Weiterhin ist gemäß dieser Darstellung erkennbar, dass die Modifikationen 9 stets in derselben Richtung ausgerichtet sind. Dies resultiert daraus, dass die Laserstrahlung definiert polarisiert ist. Gemäß Fig. 1a wird somit eine erste Polarisation verwendet, während gemäß Fig. 1b eine andere Polarisation verwendet wird. Es resultieren aus den unterschiedlichen Polarisationen bevorzugt auch unterschiedliche Schadmuster.

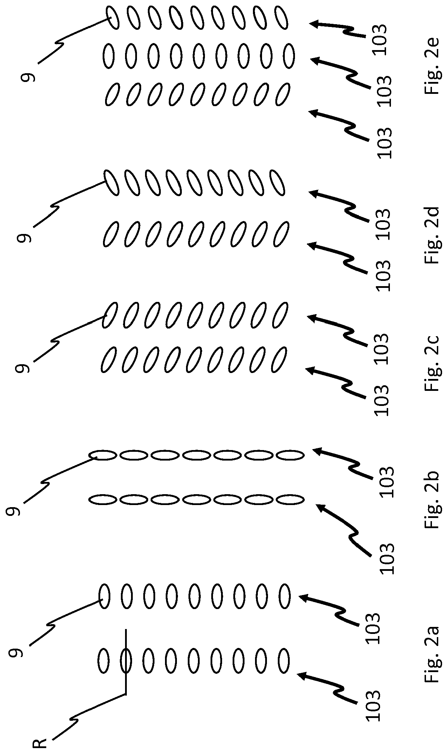

Die Figuren 2a bis 2e zeigen mehrere Beispiele für unterschiedlich polarisierte Laserstrahlung. Das Beispiel der Fig. 2a entspricht dabei dem Beispiel aus Fig. 1a und das Beispiel aus Fig. 2b entspricht dabei dem Beispiel aus Fig. 1b.

Ferner kann die Polarisation für mehrere oder alle Schreiblinien 103 zum Ausbilden eines definierten Winkels gegenüber der Längserstreckungsrichtung der Schreiblinie 103 eingestellt sein. Der Winkel kann dabei bevorzugt zwischen 0° und 90°, insbesondere zwischen 5° und 85°, insbesondere zwischen 15° und 75°, insbesondere zwischen 30° und 60°, insbesondere zwischen 40° und 50° oder bei 45° oder im Wesentlichen bei 45°, liegen. Dies wird z.B. durch die Figuren 2c bis 2e gezeigt.

Fig. 2d zeigt, dass die Modifikationen 9 unterschiedlicher Schreiblinien 103 unterschiedlich orientiert sein können. Es ist ebenfalls möglich, dass die Modifikationen 9 einer Schreiblinie abschnittsweise oder punktuell unterschiedlich definiert polarisiert sein können.

Fig. 2e zeigt eine Variante, gemäß der mehr als 2, insbesondere 3 oder mehr als 3 unterschiedliche polarisierte Schreiblinien 103 erzeugt werden.

Es ist ebenfalls denkbar, dass die Ausrichtung R einzelner oder mehrerer Modifikationen oder der Mehrzahl der Modifikationen einer linienförmigen Gestalt voneinander abweichen. Insbesondere bei gebogenen oder spiralförmigen linienförmigen Gestalten kann die Ausrichtung R der Modifikationen voneinander abweichen. Die Ausrichtung R der Modifikationen kann sich daher z.B. kontinuierlich oder stufenweise bzw. blockweise ändern, wobei ein Block bevorzugt aus mehreren, insbesondere 2-200 oder 2 bis 100 oder 2 bis 50, Modifikationen besteht.

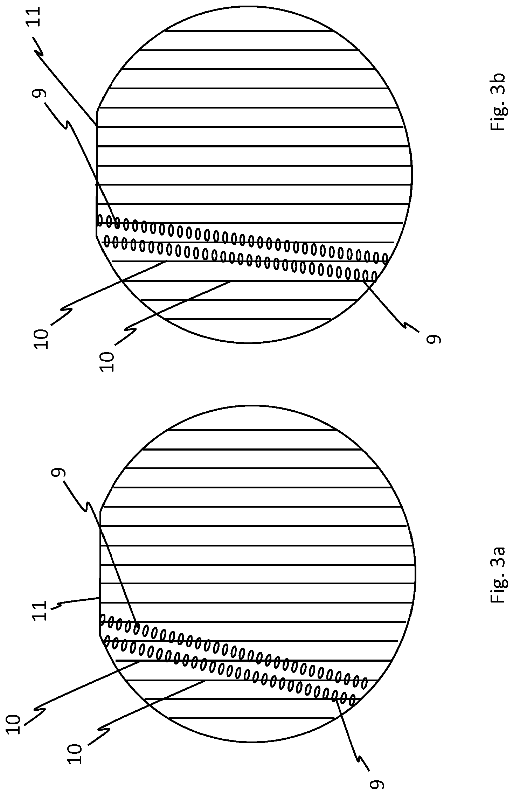

Fig. 3a zeigt, dass die Schreiblinien gegenüber den Schnittlinien 10 geneigt sein können. Je nach Ausrichtung der Polarisation gegenüber der Schreibrichtung können die so erzeugten Modifikationen 9 gegenüber der Schnittline 10 geneigt ausgerichtet sein. Fig. 3b zeigt, dass die Modifikationen in einer 90° Ausrichtung zur Schnittlinie 10 erzeugt werden können, während die Schreiblinie gegenüber der Schnittline 10 geneigt bzw. in der Ebene eingedreht ist.

Fig. 4a zeigt schematisch, dass Laserstrahlung 14 eines Lasers über eine Hauptoberfläche 8 in das Innere des Festkörpers 1 zum Verändern der Materialeigenschaften des Festkörpers 1 im Bereich von mindestens einem Laserfokus eingebracht wird, wobei der Laserfokus durch von dem Laser emittierten Laserstrahlen des Lasers gebildet wird. Die Veränderung der Materialeigenschaft bildet durch Verändern des Eindringortes der Laserstrahlung in das Spendersubstrat 1 eine linienförmige Gestalt 103 aus, wobei die Veränderungen der Materialeigenschaft auf mindestens einer, insbesondere derselben, Erzeugungsebene 4 erzeugt werden. Die Kristallgitterebenen 6 des Spendersubstrats 1 sind dabei gegenüber der Erzeugungsebene 4 geneigt, insbesondere in einem Winkel zwischen 0,1° und 9° bevorzugt von 2° oder 4° oder 8°, ausgerichtet. Die linienförmige Gestalt 103 bzw. Schreiblinie ist dabei gegenüber einer sich an der Schnittstelle zwischen der Erzeugungsebene 4 und der Kristallgitterebene 6 ergebenden Schnittlinie 10 geneigt. Durch die veränderte Materialeigenschaft reißt das Spendersubstrat 1 in Form von unterkritischen Rissen ein. Ein Schritt des Abtrennens der Festkörperschicht 2 durch Einleiten einer äußeren Kraft in das Spendersubstrat 1 zum Verbinden der unterkritischen Risse ist hierbei nicht dargestellt. Alternativ dazu kann so viel Material auf der Erzeugungsebene 4 mittels der Lasterstrahlung verändert werden, dass sich unter Verbindung der unterkritischen Risse die Festkörperschicht 2 von dem Spendersubstart 1 ablöst. Die Erzeugungsebene 4 ist bevorzugt parallel zur Hauptoberfläche 8. Andererseits des Festkörpers bzw. Spendersubstrats 1 bzw. der Kompositstruktur bildet der Festkörper bzw. das Spendersubstrat 1 bzw. die Kompositstruktur eine zweite Oberfläche

Die Bearbeitung findet in Form von Erzeugung linienförmiger Gestalten 103 bzw. Schreiblinien bzw. Linien statt, die durch Setzen einzelner Laserschüsse in einem definierten Abstand gebildet werden.

Konkret ist z.B. die Herstellung eines Wafers aus Siliziumkarbid, insbesondere vom Polytyp 4H mit einer 0001 Oberfläche mit/ohne Dotierung mit einem off-angle in Kristallachse von >0° (Industriestandard sind 4° oder 8° - um die Richtung einer Hauptachse), möglich. Da die Gleitebene der hexagonalen Kristallstruktur parallel zur 0001 Ebene verläuft, ergibt sich eine Schnittgerade der 0001 Kristallebene mit der Waferoberfläche, da diese um den off-angle relativ dazu geneigt ist.

Grundüberlegung des neuen Verfahrens ist es somit, dass die Bearbeitungsrichtung der Laserlinien 103 von der Richtung dieser Schnittgeraden abweicht. Ebenso soll die Bearbeitungsrichtung bevorzugt nicht entlang einer der Hauptrichtungen des Kristalls oder entlang der Schnittgeraden der bevorzugten Gleitebene des Kristalls mit der Oberfläche des Kristalls verlaufen.

Ferner ist z.B. die Herstellung eines Wafers aus Siliziumkarbid vom Polytyp 4H möglich. Siliziumkarbid vom Polytyp 4H weist ein hexagonales Kristallsystem mit einer Wurtzit-Struktur und einer sechsfachen-Symmetrie in der 0001 Ebene auf. Dementsprechend findet sich alle 60° eine neue Hauptachse des Kristalls. Wenn die Oberfläche durch die der Bearbeitungslaser in das zu bearbeitende Materialstück eindringt, entlang der 0001-Ebene geschnitten ist, so findet sich die sechsfache Symmetrie bei Rotation um die Oberflächennormale wieder. Hier ergibt sich dann eine Linienschreibrichtung, die um 30° zu den jeweiligen Hauptachsen rotiert und damit zwischen zwei Hauptachsen orientiert ist. Auf diese Weise wird sichergestellt, dass die geschriebene Linie die Einheitszellen des Kristalls möglichst kreuzt und sich Risse, die größere Bereiche umfassen und mehrere Einheitszellen auf einmal betreffen, schwerer ausbilden können. Siliziumkarbid vom Polytyp 4H wird oft in einem Off-Winkel von 4° relativ zur 0001-Ebene geschnitten, um Epitaxie-Schritte in der späteren Bearbeitung zu vereinfachen. Hierbei zeigt sich, dass die Projektion der Hauptachsen des Kristalls zueinander weiterhin nahezu 60° zueinander hat, weswegen 30°+/-3° bevorzugte Schreibwinkel für die erfindungsgemäße Bearbeitung ist.

Ferner ist z.B. die Herstellung eines Wafers aus kubischem SiC (sogenannt 3C) möglich. Kubisches SiC verhält sich wie kubische Kristallsysteme, hat also als bevorzugte Gleitebene die 111-Ebene, woraus sich eine bevorzugte Linienschreibrichtung von 22,5°+/-3° ergibt.

Ferner ist z.B. die Herstellung eines Wafers aus Silizium mit einer 100 Oberfläche mit/ohne Dotierung mit einem off-angle der Kristallachse von 0° möglich.

Die bevorzugte Gleitebene für Silizium mit seiner kubischen Struktur (Diamantstruktur) ist die 111 Ebene welche die Waferoberfläche im 45° Winkel zu den Kristallhauptachsen schneidet. Daraus ergibt sich damit ein angestrebter Linienschreibwinkel von 22.5°+/-3° zu den Hauptachsen des Kristalls und der Schnittgeraden der Gleitebene mit der Waferoberfläche, die zueinander in 45° Winkel orientiert sind.

Da auch Silizium-Substrate mit einem Off-Angle geschnitten sein können, kann hier wieder ein anderer Bearbeitungswinkel bevorzugt sein. Bei einer Verkippung um eine Hauptachse um einen Winkel a wird an der Oberfläche des Substrats die Symmetrie von einer 4fachen zu einer 2fachen Symmetrie durch die Kippung gebrochen. Die projizierte Länge der Hauptachse um die nicht gekippt wird, skaliert dann proportional zu cos(a), was zu einer Veränderung des Idealwinkels zwischen Hauptachsen und Schnittgerade der Gleitebene mit der Oberfläche führt. Die aufgrund der Symmetriebrechung dann möglichen zwei Linienschreibwinkel b sind dann entweder b1= tan-1(cos a)/2 oder b2= tan-1(1/cos a)/2.

Für Galliumnitrid mit einer hexagonalen Wurtzit-Struktur mit einer 6-fachen Kristallsymmetrie in der 0001-Ebene deren bevorzugte Gleitebene die 0001-Ebene ist, ergibt sich aus dem daraus folgenden Winkel von 60° für die Hauptachsen des Kristalls eine bevorzugte Linienrichtung von 30°+/-3° zu den Hauptachsen.

Für Saphir - oder Aluminiumoxid mit einer hexagonalen Korund-Struktur mit einer 6-fachen Kristallsymmetrie in der 0001-Ebene ergibt sich aus dem daraus folgenden Winkel von 60° für die Hauptachsen des Kristalls eine bevorzugte Linienrichtung von 30°+/-3° zu den Hauptachsen für sog. C-Plane-Saphir.

Für A-Plane geschnittenen Saphir ist die Hauptachsenorientierung im 90°-Winkel, mit einer 180°-Symmetrie, woraus sich ein bevorzugter Linienschreibwinkel von 45°+/-3° ergibt.

C-Plane-Substrate von Saphir sind so geschnitten, dass sich an der Oberfläche die sechsfache Symmetrie zeigt und die Oberfläche mit der Gleitebene übereinstimmt, also ein Winkel von 30°+/-3° bevorzugt ist.

Für M-Plane geschnittenen Saphir ist die Hauptachsenorientierung im 90°-Winkel, mit einer 180°-Symmetrie, woraus sich ein bevorzugter Linienschreibwinkel von 45°+/-3° ergibt.

R-Plane-Saphir hat keine Rotationssymmetrie, aber Hauptachsprojektionen in 45° zur Projektionsgeraden der Gleitebene, weswegen auch hier 22,5°+/-3° Schreibrichtung bevorzugt ist.

Für Lithiumtantalat mit einer triklinen Struktur, die mit dem hexagonalen Kristallsystem verwandt ist, ergibt sich, abhängig von der Orientierung des Substrats eine Schreibrichtung zwischen 10°+/-3° und 45°+/-3° relativ zu den einzelnen Hauptachsen und ihrer Projektion in die Substratoberfläche.

Für Galliumarsenid mit einer Zinkblende-Struktur mit einer 4-fachen Kristallsymmetrie in der 100-Ebene deren bevorzugte Gleitebene die 111-Ebene ist, ergibt sich aus dem daraus folgenden Winkel von 90° für die Hauptachsen des Kristalls eine bevorzugte Linienrichtung von 22,5°+/-3° zu den Hauptachsen des Substrats bzw. Spendersubstrats 1 mit einer 100-Oberfläche.

Für Galliumoxid mit einer monoklinen, kubischen Struktur mit einer 4-fachen Kristallsymmetrie in der 100-Ebene deren bevorzugte Gleitebene die 111-Ebene ist, ergibt sich aus dem daraus folgenden Winkel von 90° für die Hauptachsen des Kristalls eine bevorzugte Linienrichtung von 22,5°+/-3° zu den Hauptachsen des Substrats mit einer 100-Oberfläche.

Für Germanium mit einer Diamant-Struktur mit einer 4-fachen Kristallsymmetrie in der 100-Ebene deren bevorzugte Gleitebene die 111-Ebene ist, ergibt sich aus dem daraus folgenden Winkel von 90° für die Hauptachsen des Kristalls eine bevorzugte Linienrichtung von 22,5°+/-3° zu den Hauptachsen des Substrats mit einer 100-Oberfläche.

Für Indiumphosphid mit einer Zinkblende-Struktur mit einer 4-fachen Kristallsymmetrie in der 100-Ebene deren bevorzugte Gleitebene die 111-Ebene ist, ergibt sich aus dem daraus folgenden Winkel von 90° für die Hauptachsen des Kristalls eine bevorzugte Linienrichtung von 22,5°+/-3° zu den Hauptachsen des Substrats mit einer 100-Oberfläche.

Für Yttrium-Aluminium-Granat mit einer kubischen Struktur mit einer 4-fachen Kristallsymmetrie in der 100-Ebene deren bevorzugte Gleitebene die 111-Ebene ist, ergibt sich aus dem daraus folgenden Winkel von 90° für die Hauptachsen des Kristalls eine bevorzugte Linienrichtung von 22,5°+/-3° zu den Hauptachsen des Substrats mit einer 100-Oberfläche.

Fig. 4b zeigt, dass die Modifikationen 9 sehr nah, insbesondere weniger als 150µm von der Metallschicht und/oder den elektrischen Bauteilen 82 entfernt, erzeugt werden. Die Laserstrahlung wird dabei bevorzugt über die erste Oberfläche 8 in den Festkörper 1 eingebracht. Es ist hierbei wesentlich, dass nur eine sehr geringe Menge an Energie des jeweiligen Laserpulses die Metallschicht bzw. die elektrischen Bauteile erreicht. Aufgrund der Nähe der Modifikationen 9 zur Metallschicht 82 werden Laserparameter gewählt, durch die das für die Materialumwandlung erforderliche Plasma innerhalb sehr kurzer Zeit erzeugt wird. Das Plasma hat die Eigenschaft die Laserstrahlung teilweise zu absorbieren und teilweise zu reflektieren, daher reduziert es die zur Metallschicht bzw. den elektrischen Bauteilen 82 transmittierte Energiemenge signifikant. Somit können die Modifikationen 9 sehr nah an der Metallschicht und/oder den elektrischen Bauteilen 82 erzeugt werden. Das Bezugszeichen 83 kennzeichnet die als Kompositstruktur bezeichnete Gesamtheit aus Festkörper 1 und Metallschicht/en und/oder elektrischen Bauteilen.

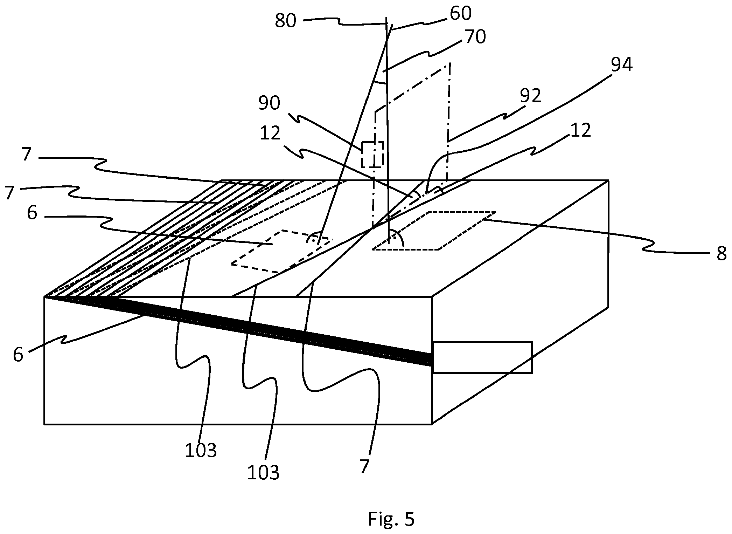

Fig. 5 zeigt einen wesentlichen Schritt des erfindungsgemäßen Verfahrens zum Abtrennen von mindestens einer Festkörperschicht 2 von einem Spendersubstrat 1 und eine geometrische Herleitung der Ausrichtung der Schreiblinie 103 bzw. der Ausrichtung der linienförmigen Gestalt.

Gemäß dieser Darstellung kann das erfindungsgemäße Verfahren auch oder alternativ die nachfolgenden Schritte umfassen:
Bereitstellen des Spendersubstrats 1, wobei das Spendersubstrat 1 Kristallgitterebenen 6 aufweist, die gegenüber einer ebenen Hauptoberfläche 8 geneigt sind, wobei die Hauptoberfläche 8 das Spendersubstrat 1 in Längsrichtung L des Spendersubstarts 1 einerseits begrenzt, wobei sich eine Kritallgitterebenennormale 60 gegenüber einer Hauptoberflächennormalen 80 in eine erste Richtung neigt, Bereitstellen von mindestens einem Laser 29, Einbringen von Laserstrahlung 14 des Lasers in das Innere des Festkörpers bzw. Spendersubstrats 1 über die Hauptoberfläche 8 zum Verändern der Materialeigenschaften des Festkörpers im Bereich von mindestens einem Laserfokus, wobei der Laserfokus durch von dem Laser emittierten Laserstrahlen des Lasers gebildet wird, wobei die Veränderung der Materialeigenschaft durch Verändern des Eindringortes der Laserstrahlung in das Spendersubstrat 1 eine linienförmige Gestalt ausbildet, wobei sich die linienförmige Gestalt bevorzugt zumindest abschnittsweise geradlinig erstreckt und wobei die linienförmige Gestalt, insbesondere zumindest der sich geradlinig erstreckende Abschnitt, parallel zur Hauptoberfläche 8 erzeugt wird und sich dabei in einer zweiten Richtung erstreckt, die gegenüber der ersten Richtung in einem Winkel geneigt ist, der von 90° verschieden ist, wobei durch die veränderten Materialeigenschaft das Spendersubstrat 1 in Form von unterkritischen Rissen einreißt, Abtrennen der Festkörperschicht durch Einleiten einer äußeren Kraft in das Spendersubstrat zum Verbinden der unterkritischen Risse oder so viel Material auf der Erzeugungsebene mittels der Lasterstrahlung verändert wird, dass sich unter Verbindung der unterkritischen Risse die Festkörperschicht von dem Spendersubstart ablöst. Die Hauptoberfläche ist dabei bevorzugt Bestandteil der abgetrennten Festkörperschicht 2.

Die zweite Richtung ist dabei bevorzugt gegenüber der ersten Richtung in einem Winkelbereich zwischen 45° und 87°, insbesondere in einem Winkelbereich zwischen 70° und 80° und bevorzugt mit 76°, geneigt.

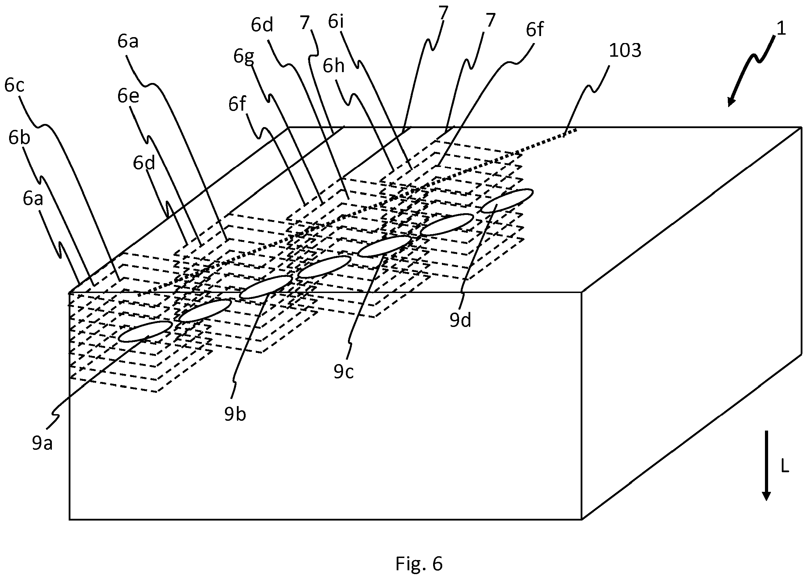

Fig. 6 zeigt, dass die linienförmige Gestalt 103 bzw. die Schreiblinie gegenüber den Enden der Kristallgitterebene oder wie in Fig. 5 gezeigt gegenüber einer sich an der Schnittstelle zwischen der Erzeugungsebene 4 und der Kristallgitterebene 6 ergebenden Schnittlinie 10 bzw. Schnittgeraden geneigt ist. Durch diese Ausrichtung wird das Risswachstum in Richtung der Kristallgitterebenen 6 (insbesondere Gleitebenen) begrenzt. Die Modifikationen 9 je Schreiblinie werden somit nicht in denselben Kristallgitterebenen 6 erzeugt. Z.B. die ersten 1-5% der Modifikationen je Schreiblinie 103 können somit nur noch einen Bruchteil, insbesondere weniger als 75% oder weniger als 50% oder weniger als 25% oder weniger als 10% oder keine Kristallgitterebenen, der letzten 1-5% der Modifikationen derselben Schreiblinie 103 in Substratlängsrichtung L schneiden. Dieser Zusammenhang wird insbesondere dadurch schematisch verdeutlicht, dass die Modifikation 9a die Kristallgitterebenen 6a-6c schneidet und die Modifikation 9b die Kristallgitterebenen 6a, 6d und 6e schneidet. Somit schneiden zwei Modifikationen 9a und 9b obwohl sie Bestandteil derselben linearen Gestalt 103 bzw. Schreiblinie sind, unterschiedliche Kristallgitterebenen. Ferner ist ersichtlich, dass z.B. die Modifikationen 9c und 9d bevorzugt andere, insbesondere mehrheitlich oder vollständig andere, Kristallgitterebenen schneidet als die Modifikation 9a.

Die auf der Hauptoberfläche 8 endenden Enden 7 der Kristallgitterebenen 6 bildet in einer mikroskopischen Schnittdarstellung bevorzugt eine Art Sägezahnmuster aus.

Die einzelnen Kristallgitterebenen 6 sind bevorzugt in einem Winkel zwischen 0,1° und 10°, insbesondere zwischen 2° und 9°, wie z.B. 4° oder 8°, gegenüber der Längsachse L geneigt. Bevorzugt sind die einzelnen Kristallgitterebenen des Spendersubstrats 1 parallel zueinander ausgerichtet.

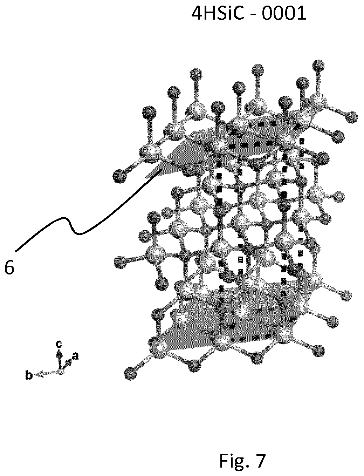

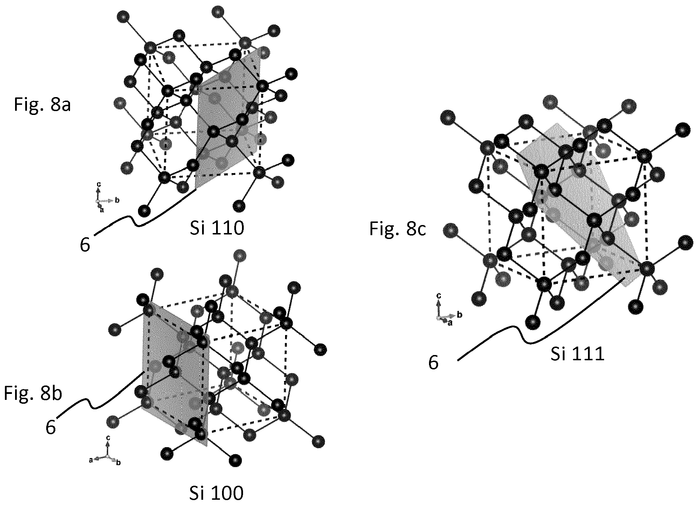

Fig. 7 zeigt ein Beispiel eines Kristallgitters mit Gleitebene für 4HSiC; Fig. 8a zeigt ein Beispiel eines Kristallgitters mit Gleitebene 110 für Si; Fig. 8b zeigt ein Beispiel eines Kristallgitters mit Gleitebene 100 für Si und Fig. 8c zeigt ein Beispiel eines Kristallgitters mit Gleitebene 111 für Si.

Bevorzugt handelt es sich bei den Kristallgitterebenen 6 um Gleitebenen eines bestimmten Typs. Ist die Kristallstruktur kubischflächenzentriert, dann ist die Gleitebene bevorzugt die Ebene {111} und die Gleitrichtung die Richtung <110>. Ist die Kristallstruktur kubischraumzentriert, dann ist die Gleitebene bevorzugt die Ebene {110} und die Gleitrichtung die Richtung <111> oder die Gleitebene ist bevorzugt die Ebene {112} und die Gleitrichtung ist die Richtung <111> oder die Gleitebene ist bevorzugt die Ebene {123} und die Gleitrichtung ist die Richtung <111>. Ist die Kristallstruktur hexagonal, dann ist die Gleitebene bevorzugt die Ebene {0001} und die Gleitrichtung die Richtung <1120> oder die Gleitebene ist bevorzugt die Ebene {1010} und die Gleitrichtung ist die Richtung <1120> oder die Gleitebene ist bevorzugt die Ebene {1011} und die Gleitrichtung ist die Richtung <1120>.

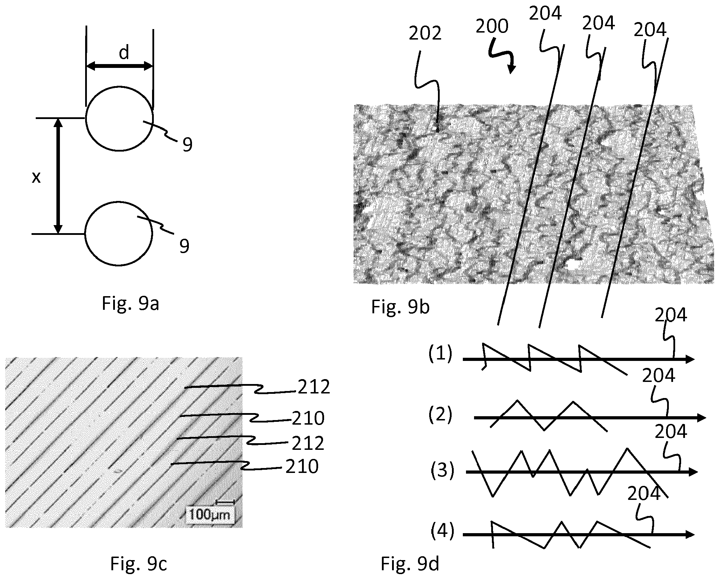

Fig. 9a zeigt die theoretische Basis für die Bedingung (d-x)/d<y, wobei y bevorzugt -0,31 ist oder kleiner als 0,31 oder kleiner als 0,35 oder kleiner als 0,4 ist. Hierbei gilt bevorzugt ferner d = 1.22 * Lambda / NA - beugungsbegrenzte Fokusgröße. x ist bevorzugt der Abstand der Punkte bzw. der Abstand der Zentren zweier nacheinander auf einer linienförmigen Gestalt erzeugten Fokuspunkte. Bevorzugt gilt ferner x> d. Bevorzugt wird erfindungsgemäß einer numerischen Apertur verwendet, die größer ist als 0,5 oder die größer ist als 0,6 oder die größer ist als 0,65 oder die größer ist als 0,7 oder die größer ist als 0,75 oder die größer ist als 0,8 oder die größer ist als 0,85.

Fig. 9b zeigt eine durch einen Abtrennschritt freigelegte Oberfläche 200 einer von einem Festkörper abgetrennten Festkörperschicht. Die Oberfläche 200 weist dabei eine Topografie auf, wobei die Topografie längliche zick-zack-förmige Erhebungen aufweist. Die sich länglichen zick-zack förmigen Erhebungen erstrecken sich mehrheitlich und jeweils in ihrer Gesamtheit in einer Richtung 204 oder mehreren Richtungen 204, die von einer Richtung, die parallel zu den Kristallgitterebenen und parallel zur Oberfläche steht verschieden ist, insbesondere dazu in einem Winkel zwischen 2° und 30°, insbesondere zwischen 3° und 15°, insbesondere zwischen 4° und 9°, geneigt ist. Bevorzugt beträgt die mittlere Höhe der zick-zack-förmigen Erhebungen oder die maximale Höhe der zick-zack-förmigen Erhebungen, insbesondere gegenüber der tiefsten Stelle der Oberfläche, weniger als 100 µm, insbesondere weniger als 75µm oder weniger als 50µm oder weniger als 30µm.

Da die Laserenergieschwelle zur Erzeugung eines gleichen Rissbilds oder Schwärzung, d.h. Phasenumwandlung/Lasermodifikation, bei einem Winkel der geschriebenen Linie zum Hauptflat, der nicht null ist, abhängig von der Überfahrtrichtung ist, kann es vorteilhaft sein, die Laserenergie für die jeweilige Bearbeitungsrichtung anzupassen. Dies ist in Fig. 9c gezeigt, wo eine Mäanderfahrt zur Bearbeitung durchgeführt wurde und jede zweite Linie 210 (Bearbeitungsrichtung 1) eine andere Modifikationsstärke aufweist als die jeweils benachbarten Linien 212 (Bearbeitungsrichtung 2).

Dementsprechend würden die schwächer ausgebildeten Linien zu einer entsprechend höheren Laserenergie angepasst um das Schadbild möglichst gleichmäßig auszubilden und damit in jeder Linienfahrt eine gleich große Rissbildungswahrscheinlichkeit zu erhalten.

Fig. 9d zeigt vier verschiedene zick-zack förmige Linien (1)-(4). Diese Linien geben schematisch Beispiele vor, welche die Erhebungen 202 oder Vertiefungen aufweisen können. Die Erhebungen 202 oder Vertiefungen können sich dabei abschnittsweise gleichförmig oder in etwa gleichförmig wiederholen. Sich gleichmäßig wiederholende Zick-Zack Muster werden durch die Muster (1) und (2) gezeigt. Die Erhebungen und Vertiefungen weisen dabei bevorzugt stets einen ersten Anteil auf, der sich in eine erste Richtung erstreckt und einen zweiten Anteil der sich in eine zweite Richtung erstreckt. Bevorzugt wiederholen sich diese Anteile entlang einer Richtung 204, insbesondere entlang der Schreibrichtung bzw. entlang der Richtung, in der die Modifikationen einer linienförmigen Gestalt erzeugt wurden. Es ist hierbei jedoch auch möglich, dass der erste Anteil "je Zacken" oder bei "einzelnen Zacken" gegenüber einer mittleren Länge länger erstreckt oder kürzer erstreckt. Es ist hierbei jedoch zusätzlich oder alternativ auch möglich, dass der zweite Anteil "je Zacken" oder bei "einzelnen Zacken" gegenüber einer mittleren Länge länger erstreckt oder kürzer erstreckt. Bevorzugt kann sich die erste Richtung je Zacken in einem Winkelbereich zwischen 0° und 45°, insbesondere in einem Winkelbereich zwischen 0° und 20° oder zwischen 0° und 5°, verändern. Bevorzugt kann sich zusätzlich oder alternativ die zweite Richtung je Zacken in einem Winkelbereich zwischen 0° und 45°, insbesondere in einem Winkelbereich zwischen 0° und 20° oder zwischen 0° und 5°, verändern. Die Beispiele (3) und (4) zeigen Rissverläufe mit variablen Längenanteilen und Winkeln.

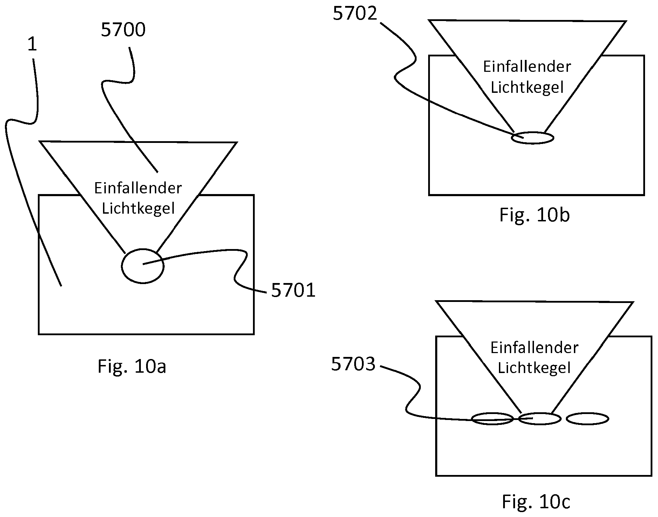

Fig. 10a zeigt einen einfallenden Lichtkegel 5700, durch den im Festkörper 1 ein Fokus 5700 erzeugt wird. Dargestellt ist dabei ein Fokusabbild eines Objektivs durchstrahlt von einem Laser mit Gaußschen Strahlprofil.

Fig. 10b stellt schematisch ein Fokusabbild 5702 eines Objektivs durchstrahlt von einem Laser mit NICHT-Gaußschen Strahlprofil dar, z.B. nachdem der Strahl durch einen SLM verändert wurde. Ein Spatial light modulator (SLM) ist dabei ein räumlicher Modulator für Licht und somit ein Gerät durch das Licht eine räumliche Modulation aufprägbar ist. Gegenüber dem Gaußschen Strahlprofil ist die Z-Ausdehnung des Fokuspunktes deutlich reduziert bzw. reduzierbar.

Fig. 10c stellt schematisch ein Fokusabbild 5703 eines Objektivs durchstrahlt von einem Laser mit NICHT-Gaußschen Strahlprofil dar, z.B. nachdem der Strahl durch einen diffraktives optisches Element (DOE) verändert wurde. Der Strahl ist dabei bevorzugt zum Ausbilden mehrerer Fokusse durch das DOE aufgeteilt. Ein DOE dient dabei bevorzugt dazu die Beugung eines Laserstrahls um die räumliche Abbildung des Fokuspunktes zu verändern.

Diffraktive optische Elemente (DOEs) wirken durch Beugung auf Laserstrahlung ein. Hierbei werden Strukturen verwendet, die auf der Größenskala der Laserwellenlänge liegen. Mittels numerischer Simulation der Lichtbeugung an beugenden Strukturen wird ein Element berechnet, was dann in größeren Stückzahlen hergestellt werden kann. Generell wird die räumliche Verteilung des Lichts im Laserstrahlprofil geändert, entweder direkt nach dem Element oder im Brennpunkt nach einem fokussierenden Element. Dies bedeutet, dass z.B. ein Strahl in mehrere Strahlen aufgespalten werden kann, dass ein - üblicherweise auftretendes - Gauß-Strahlintensitätsprofil in eine andere Form überführt wird, oder dass sich die Intensitätsverteilung der Laserstrahlung im Fokus in einer durch herkömmliche Linsen nicht erreichbaren Weise ändert, z.B. durch das bewusste Einbringen oder Unterdrücken von Nebenmaxima, die für die erwünschte Laserwechselwirkung erforderlich sind.

Im Gegensatz dazu ist ein räumlicher Modulator für Licht (englisch: Spatial Light Modulator (SLM)) ein Gerät, um Licht eine räumliche Modulation aufzuprägen.

Gewöhnlicherweise moduliert ein SLM die Intensität eines Lichtstrahls, es ist jedoch auch möglich, die Phase oder auch die Phase und die Intensität gleichzeitig zu modulieren.

Diese räumliche Modulation wird beim DOE durch die Strukturen im Element vorgenommen, beim SLM hingegen durch die einzelnen Pixel am SLM. Besonders nach Abbildung oder Fokussierung eines intensitäts- und phasenmodulierten Strahls sind damit programmierbare Intensitätsverteilungen im Fokus zu erreichen. Während ein DOE also statisch und reproduzierbar auf den Laserstrahl wirkt, kann z.B. mit Hilfe eines SLM die Zahl der Strahlen oder auch das verwendete Laserstrahlprofil in einer Laserbearbeitungsvorrichtung dynamisch umgeschaltet werden. Auch ist eine dynamische Anpassung im Prozessverlauf möglich, z.B. nach Feedback einer gleichzeitigen Überwachung des Prozessfortschritts.

Das hiermit vorgeschlagene Verfahren weist erfindungsgemäß den Schritt des Veränderns einer Strahleigenschaften der Laserstrahlen vor dem Eindringen in den Festkörper auf, wobei die Strahleigenschaft die Intensitätsverteilung im Fokus ist, wobei die Veränderung oder Anpassung der Strahleigenschaft von mindestens oder genau einem Spatial Light Modulator und/oder von mindestens oder genau einem DOE bewirkt wird, wobei der Spatial Light Modulator und/oder das DOE im Strahlengang der Laserstrahlung zwischen dem Festkörper und der Strahlungsquelle angeordnet ist.

Zur Erläuterung der Funktionsweise von DOEs und Spatial Light Modulatoren wird auf die nachfolgend genannte Druckschrift verwiesen: Flexible beam shaping system for the next generation of process development in laser micromachining, LANE 2016, 9th International Conference on Photonic Technologies LANE 2016, Tobias Klerks, Stephan Eifel.

Laserstrahlintensitätsprofile die von der normalerweise üblichen Gaußform abweichen werden als nicht-Gaußsche Strahlenprofile bezeichnet und können eingesetzt werden, um ein anderes Bearbeitungsergebnis zu erzielen. So ist z.B. ein Linienfokus denkbar, der in einer Dimension senkrecht zur Strahlfortpflanzungsrichtung eine deutlich andere Ausdehnung aufweist als in einer zweiten Dimension. Dies ermöglicht ein Überstreichen breiterer Bereiche des Werkstücks mit dem Laserstrahl im Bearbeitungsschritt. Auch ist ein "top-hat"-Profil bekannt, dass eine konstante Intensität im Zentrum des Strahls aufweist, was den Vorteil bietet, dass in der Bearbeitung im Fokus keine Bereiche unterschiedlicher Intensität vorliegen oder zumindest nur Bereiche gleicher Intensität über der Laserbearbeitungsschwelle liegen. Dies kann zum Beispiel zur Minimierung der Schleifverluste nach dem Trennen dienen.

Die vorliegende Erfindung bezieht sich somit bevorzugt auf ein Verfahren zum Erzeugen von Modifikationen 9 im Inneren eines Festkörpers 1. Das Verfahren weist dabei bevorzugt den Schritt des Einbringens von Laserstrahlung 14 eines Lasers 29 über eine erste Oberfläche 8 des Festkörpers 1 in das Innere des Festkörpers 1 auf. Die Oberfläche 8, über welche die Laserstrahlung 14 in den Festkörper 1 eindringt, ist bevorzugt Bestandteil der abzutrennenden Festkörperschicht. Bevorzugt ist die abzutrennende Festkörperschicht dünner als der verbleibende Restfestkörperanteil.

Bevorzugt bildet der Festkörper 1 eine Kristallstruktur aus und durch die Laserstrahlung 14 werden Modifikationen 9 an vorbestimmten Stellen auf einer Erzeugungsebene 4 im Inneren des Festkörpers 1 erzeugt. Die Erzeugungsebene ist dabei bevorzugt parallel zur ersten Oberfläche 8. Die Modifikationen 9 sind bevorzugt näher zur ersten Oberfläche 8 beabstandet als zu einer zweiten Oberfläche, wobei die zweite Oberfläche bevorzugt parallel zur ersten Oberfläche 8 ausgebildet ist. Durch die Modifikationen 9 werden mehrere linienförmige Gestalten 103, insbesondere gepunktete oder durchgängige Schreiblinien, erzeugt, wobei der Festkörper 1 im Bereich der jeweiligen Modifikation 9 unterkritisch einreißt, wobei die unterkritischen Risse orthogonal zur Längserstreckungsrichtung der jeweiligen linienförmigen Gestalt eine Risslänge bzw. mittlere Risslänge von weniger als 150 µm, insbesondere von weniger als 120 µm oder weniger als 110 µm oder weniger als 90 µm oder weniger als 75 µm oder weniger als 60 µm, aufweist.

Als "im Bereich" der Modifikation 9 kann hierbei derart verstanden werden, dass der Festkörper 1 im modifizierten bzw. materialumgewandelten Anteil und im sich dazu benachbarenden Festkörperanteil einreißt. Es ist jedoch ebenfalls möglich, dass der modifizierte Bereich nicht einreißt, sondern der Riss in Festkörperlängsrichtung oberhalb oder unterhalb der Modifikation/en einreißt. Reißt der Festkörper oberhalb oder unterhalb der Modifikation/en ein, dann beträgt der Abstand des Risses (insbesondere des unterkritischen Risses) zur Erzeugungsebene bevorzugt weniger als 20µm, insbesondere weniger als 15µm oder weniger als 10µm oder weniger als 5µm oder weniger als 4µm oder weniger als 3µm oder weniger als 2µm oder weniger als 1µm.

Die Modifikationen 9, die zur selben linienförmigen Gestalt 103 gehören und nacheinander erzeugt werden, werden bevorzugt in einem Abstand zueinander erzeugt, der durch die Funktion (d-x)/d<-0,31, insbesondere <-0,4 , definiert wird.

Zusätzlich oder alternativ kann die Laserstrahlung definiert polarisiert sein. Die Polarisationsrichtung der Laserstrahlung 14 ist dabei bevorzugt in einem definierten Winkel oder in einem definierten Winkelbereich gegenüber der Kristallachse des Festkörpers 1 orientiert oder die Längserstreckungsrichtung R der mittels der Laserstrahlen 14 im Inneren des Festkörpers 1 erzeugten Modifikationen 9 in einem definierten Winkel oder in einem definierten Winkelbereich gegenüber einer sich an der Schnittstelle zwischen der Erzeugungsebene 4 und der Kristallgitterebene 6 ergebenden Schnittlinie 10 ausgerichtet ist.

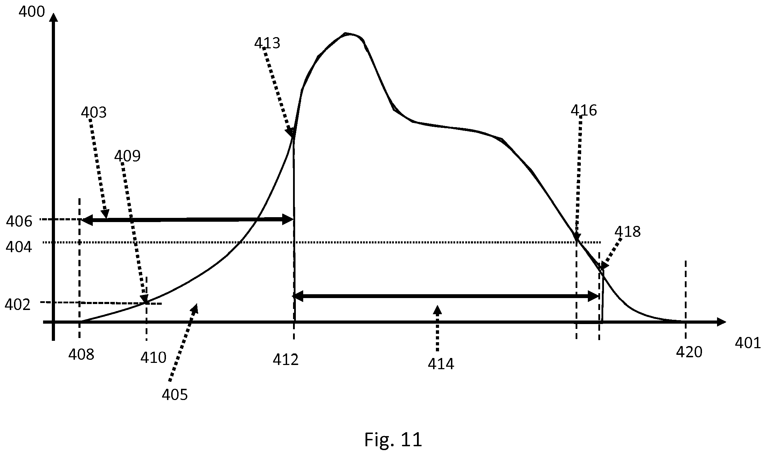

Fig. 11 zeigt eine Strahlungsintensitätsverteilung im Fokus 400 über die Zeit 401.

Das Bezugszeichen 402 kennzeichnet hierbei I_{MP} bzw. die Strahlungsintensität im Fokus, bei welcher der Multiphotonenprozess-onset erfolgt. Der Multiphotonenprozess-onset wird hierbei durch das Bezugszeichen 409 gekennzeichnet. Das Bezugszeichen 410 kennzeichnet hierbei tₘₚ bzw. die Zeit nach dem Pulsstart 408 bei der der Multiphotonenprozess-onset erfolgt. Als Transmissionszeit 403 wird hierbei die Zeit ab dem Pulsstart 408 bis zur Modifikationserzeugung verstanden. Die Transmissionszeit 403 kann hierbei eine Plasmakonditionierzeit umfassen.

Das Bezugszeichen 404 kennzeichnet hierbei I_{BD} bzw. die Strahlungsintensität im Fokus, bei welcher ein Elektronen Plasma Breakdown erfolgt. D.h. ab diesem Moment ist das Elektronenplasma aufgelöst. Das Bezugszeichen 405 kennzeichnet die Energie zur Elektronenerzeugung, diese wird zum Großteil transmittiert. Daher ist eine Verkürzung dieser Zeit im Sinne der vorliegenden Erfindung. Das Bezugszeichen 406 kennzeichnet hierbei I_{ON} bzw. die Strahlungsintensität im Fokus, bei welcher ein Modifikations-onset 413 erfolgt. D.h. ab diesem Moment erfolgt eine Materialumwandung bzw. Phasenumwandung. Entsprechend kennzeichnet das Bezugszeichen 412 die Zeit nach dem Pulsstart 408 bei welcher der Modifikations-onset erfolgt. Das Bezugszeichen 414 gibt hierbei die Modifikationszeit an, d.h. die Zeit in der eine Materialumwandung erfolgt.

Das Bezugszeichen 416 kennzeichnet hierbei einen Elektronen Plasma Breakdown I_{BD}<I_{ON} da Absorption BD> Absorption ON. Der Elektronen Plasma Breakdown für zu einem zeitlich unmittelbar nachgelagerten Modifikations-breakdown 418. Das Bezugszeichen 420 kennzeichnet das Pulsende des Laserpulses.

Hieraus ergibt sich ein erfindungsgemäßes Verfahren. Dieses erfindungsgemäße Verfahren dient bevorzugt zum Erzeugen von Modifikationen 9 im Inneren eines Festkörpers 1 und weist bevorzugt mindestens die nachfolgend genannten Schritte auf: Einbringen von Laserstrahlung 14 eines Lasers 29 über eine erste Oberfläche 8 des Festkörpers 1 in das Innere des Festkörpers 1, wobei der Festkörper 1 eine Kristallstruktur ausbildet und wobei durch die Laserstrahlung 14 Modifikationen 9 an vorbestimmten Stellen auf einer Erzeugungsebene 4 im Inneren des Festkörpers 1 zum Vorgeben einer Ablöseebene erzeugt werden, wobei die Laserstrahlung je Modifikation das Konditionieren eines Plasmas zum Modifizieren des Festkörpers bewirkt, wobei das Plasma für eine Modifikationserzeugungszeit 414 existent gehalten wird, wobei ab dem Beginn eines Laserpulses und bis unmittelbar vor der Konditionierung des Plasmas eine Transmissionszeit 403 liegt, in der die Laserstrahlung zumindest teilweise durch den Festkörper hindurch läuft, wobei die Konditionierung des Plasmas in einer Plasmakonditionierungszeit 412 erfolgt, wobei das Plasma beaufschlagende Laserstrahlung zumindest mehrheitlich und bevorzugt vollständig vom Plasma absorbiert und/oder reflektiert und/oder gestreut wird, wobei die Gesamtzeit aus Modifikationserzeugungszeit 414, Transmissionszeit 403 und Plasmakonditionierungszeit, insbesondere Zündung und Aufheizung des Plasmas, mindestens 70% einer Pulsdauer der Laserstrahlung während der Erzeugung der Modifikation entspricht, wobei die Pulsdauer kleiner als 100ns, insbesondere kleiner als 10ns oder kleiner als 5ns oder kleiner als 3ns oder kleiner als 2ns oder kleiner als 1ns ist. Die Laserstrahlung erzeugt im Fokuspunkt eine definierte Strahlungsintensität, durch die sich eine definierte Elektronendichte ergibt, wobei die Elektronendichte im Fokuspunkt innerhalb der Transmissionszeit einen vordefinierten Schwellenwert überschreitet, wobei die Transmissionszeit kürzer ist als 70ns. Die Transmissionszeit ist besonders bevorzugt kürzer als 2ns, insbesondere kürzer ist als 1ns oder 0,75ns oder 0,5ns.

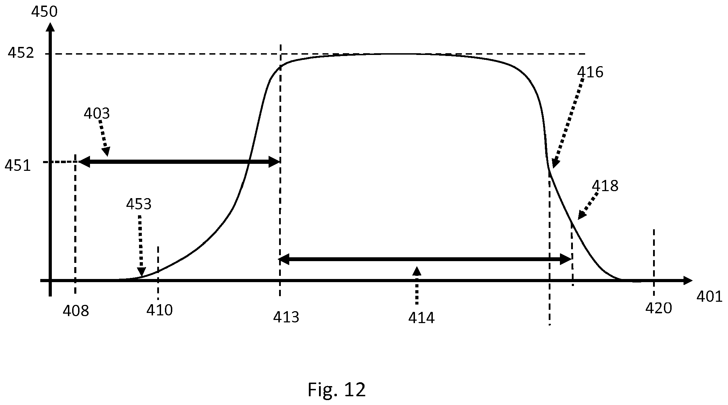

Fig. 12 zeigt einen Verlauf der Elektronendichte 450 über die Zeit 401. Das Bezugszeichen 451 kennzeichnet den Punkt des Plasma-onset, d.h. den Moment, in dem das Plasma gebildet ist und beginnt Laserstrahlung zu absorbieren, Reflektieren und zu Streuen bzw. den Moment ab dem das Plasma eine Transmission der Laserstrahlen zur Metallschicht bzw. metallischen Struktur bzw. den elektrischen Bauteilen reduziert bzw. verhindert. Das Bezugszeichen kennzeichnet die maximale Elektronendichte. Das Elektronenplasma oszilliert hierbei bevorzugt mit der Laserstrahlung.

Im Falle vorhandener Absorptionskeime würde die Elektronendichte ab dem Pulsstart stärker ansteigen, wodurch die Transmissionszeit 403 kürzer wäre. Für diesen Fall kennzeichnet das Bezugszeichen 453 eine lineare Absorption durch schon vorhandene amorphisierte Kristallgebiete.

Es ist somit ein weiteres Verfahren zum Erzeugen von Modifikationen 9 im Inneren eines Festkörpers 1 möglich. Dieses weitere Verfahren umfasst dabei bevorzugt die Schritte des Einbringens von Laserstrahlung 14 eines Lasers 29 über eine erste Oberfläche 8 des Festkörpers 1 in das Innere des Festkörpers 1. Der Festkörper 1 bildet dabei bevorzugt eine Kristallstruktur aus. Durch die Laserstrahlung 14 werden Modifikationen 9 an vorbestimmten Stellen auf einer Erzeugungsebene 4 im Inneren des Festkörpers 1 erzeugt. Die zweite Oberfläche 81 ist dabei bevorzugt parallel zur ersten Oberfläche 8 ausgebildet. Durch die Modifikationen 9 werden bevorzugt mehrere linienförmige Gestalten 103, insbesondere Schreiblinien, erzeugt. Der Festkörper 1 reißt dabei bevorzugt im Bereich der jeweiligen Modifikation 9 unterkritisch ein, wobei die unterkritischen Risse bevorzugt orthogonal oder im Wesentlichen orthogonal zur Längserstreckungsrichtung der jeweiligen linienförmigen Gestalt eine mittlere Risslänge von weniger als 150 µm, insbesondere von weniger als 120 µm oder weniger als 110 µm oder weniger als 90 µm oder weniger als 75 µm oder weniger als 60 µm, aufweisen. Die Laserstrahlung ist hierbei bevorzugt definiert polarisiert, insbesondere linear polarisiert, wobei die Polarisationsrichtung der Laserstrahlung 14 besonders bevorzugt in einem definierten Winkel oder in einem definierten Winkelbereich gegenüber der Kristallachse des Festkörpers 1 orientiert ist. Zusätzlich oder alternativ

Ist die Längserstreckungsrichtung R der mittels der Laserstrahlen 14 im Inneren des Festkörpers 1 erzeugten Modifikationen 9 in einem definierten Winkel oder in einem definierten Winkelbereich gegenüber einer sich an der Schnittstelle zwischen der Erzeugungsebene 4 und der Kristallgitterebene 6 ergebenden Schnittlinie 10 ausgerichtet.

Die Laserstrahlung bewirkt bevorzugt je Modifikation das Konditionieren eines Plasmas zum Modifizieren des Festkörpers. Das Plasma wird dabei bevorzugt für eine Modifikationserzeugungszeit 414 existent gehalten, wobei unmittelbar vor der Konditionierung des Plasmas und ab dem Beginn eines Laserpulses eine Transmissionszeit 403 liegt, in der die Laserstrahlung zumindest teilweise durch den Festkörper hindurch läuft, wobei die Konditionierung des Plasmas in einer Plasmakonditionierungszeit erfolgt, wobei das Plasma beaufschlagende Laserstrahlung zumindest mehrheitlich und bevorzugt vollständig vom Plasma absorbiert und/oder reflektiert und/oder gestreut wird. Die Plasmakonditionierungszeit liegt bevorzugt zwischen der Transmissionszeit und der Modifikationszeit und kann sehr klein sein, insbesondere kürzer als 1ns oder kürzer als 0,1ns oder kürzer als 0,01ns. Die Gesamtzeit aus Modifikationserzeugungszeit 414, Transmissionszeit 403 und Plasmakonditionierungszeit (nicht dargestellt), insbesondere Zündung und Aufheizung des Plasmas, ist bevorzugt kleiner als 10ns, insbesondere kleiner als 4ns. Die Laserstrahlung im Fokuspunkt erzeugt somit bevorzugt eine definierte Strahlungsintensität, durch die sich eine definierte Elektronendichte ergibt, wobei die Elektronendichte im Fokuspunkt so groß ist, dass die Transmissionszeit besonders bevorzugt kürzer ist als die Modifikationserzeugungszeit. Während der Modifikationserzeugungszeit wird somit durch das Plasma, insbesondere infolge eines thermischen Effekts, insbesondere einer Aufheizung des Festkörpermaterials auf bzw. über eine Phasenumwandungstemperatur die Phasenumwandung bewirkt.

Es erfolgt bevorzugt eine sehr genaue Einstellungen der Laserpulsflanken, also des zeitlichen Bereichs, bei dem die Laserpulsenergie bis zu ihrem Maximum ansteigt bzw. wieder vom Maximum wieder unter einen Grenzwert abfällt, sowie der individuellen Laserintensitätsverteilung über den Verlauf eines einzelnen Laserpulses. Bei spektral verbreiterten Pulsen ist zum Beispiel durch einen sog. "chirp" - eine in der Zeit versetzte Anordnung einzelner Frequenzen der Laserstrahlung - eine asymmetrische, vom Gauß-Profil abweichende Intensitätsverteilung erzielbar.

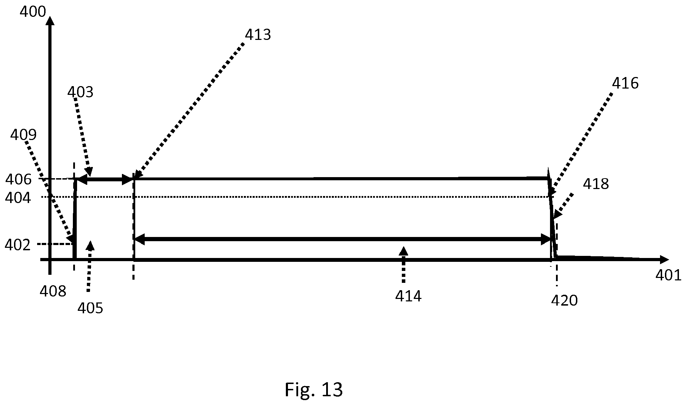

Fig. 13 zeigt einen solche alternativen Strahlungsintensitätsverlauf im Fokus 400 über der Zeit 401 bzw. eine idealisierte Pulsform mit vorteilhaften Eigenschaften. Durch den steilen Anstieg der Strahlungsintensität ist die Transmissionszeit 403 sehr kurz, wodurch relativ wenig Strahlung bis zur Metallschicht bzw. metallischen Struktur bzw. den elektrischen Bauteilen transmittieren kann. Durch die bevorzugt ebenfalls sehr genau einstellbare Länge der Modifikationszeit lässt sich die Modifikationsausbildung sehr präzise steuern.

Die vorliegende Erfindung bezieht sich somit auf ein Verfahren zum Erzeugen von Mikrorissen 9 im Inneren einer Kompositstruktur 83. Das erfindungsgemäße Verfahren umfasst dabei bevorzugt mindestens die Schritte: Bereitstellen oder Erzeugen der Kompositstruktur 83, wobei die Kompositstruktur 83 einen Festkörper 1 und zumindest eine einerseits des Festkörpers 1 angeordnete oder ausgebildete metallische Beschichtung und/oder elektrische Bauteile 82 aufweist und andererseits eine ebene Oberfläche 8 ausbildet, wobei der Festkörper 1 Siliziumcarbid (SiC) aufweist oder daraus besteht, Erzeugen von Modifikationen 9 im Inneren des Festkörpers 1, wobei Laserstrahlung 14 über die ebene Oberfläche 8 in den Festkörper 1 eingebracht wird, wobei die Laserstrahlung 14 eine Mehrphotonenanregung bewirkt, wobei die Mehrphotonenanregung eine Plasmaerzeugung bewirkt, wobei die Modifikation durch das Plasma in Form einer Materialumwandlung bewirkt wird, wobei die Materialumwandungen Druckspannungen im Festkörper 1 erzeugen, wobei der Festkörper 1 in einem umliegenden Bereich der jeweiligen Modifikation 9 unterkritisch einreißt, wobei die Modifikationen 9 in einem Abstand von weniger als 150 µm zur metallischen Beschichtung und/oder den elektrischen Bauteilen 82 erzeugt werden, wobei die Laserstrahlung 14 in Pulsen in den Festkörper 1 eingebracht wird. Die Pulsintensität eines Pulses erreicht dabei bevorzugt innerhalb von 10ns ab dem Beginn des jeweiligen Pulses die maximale Pulsintensität.

**Bezugszeichenliste**

| | | | |
|---|---|---|---|
| 1 | Festkörper / Spendersubstrat | 81 | zweite Oberfläche |
| 2 | Festkörperschicht | 82 | Metallschicht oder elektrische Bauteile |
| 4 | Erzeugungsebene | 83 | Kompositstruktur |
| 5 | Ort zur Modifikationserzeugung | 90 | Normalebene |
| 6 | Kristallgitterebene | 92 | Orthogonalebene zur Normalenebene |
| 6a/b/c | Kristallgitterebenen | 94 | Erstreckungsrichtung der Enden der Kristallgitterebenen |
| 7 | Ende der Kristallgitterebene | | |
| 8 | Hauptoberfläche /erste Oberfläche | 103 | Laserlinie / Schreiblinie / linienförmige Gestalt |
| 9 | Modifikation | 200 | Durch Abtrennen freigelegte Oberfläche der Festkörperschicht |
| 9a/b | Modifikationen | | |
| 10 | Schnittlinie | 202 | zick-zack-förmige Erhebungen |
| 12 | unterkritischer Riss | 204 | Richtung der Erstreckung der zick-zack-förmige Erhebung/en |
| 11 | Flat | | |
| 13 | mechanische Spannungen | 210 | erste Richtung |
| 14 | Laserstrahlung | 212 | zweite Richtung (entgegengesetzt zur ersten Richtung 210) |
| 29 | Laser | 400 | Strahlungsintensität im Fokus |
| 30 | Umpositioniereinrichtung | 401 | Zeit |
| 32 | Laserstrahlung | 402 | I_{MP} Strahlungsintensität im Fokus, bei welcher der Multiphotonenprozess-onset erfolgt |
| 45 | Rotationseinrichtung | | |
| 49 | Zentrum | | |
| 50 | Drehzentrum | 403 | Transmissionszeit |
| 51 | Verbindungsstrecke | 404 | I_{BD} Strahlungsintensität im Fokus, bei welcher ein Elektronen Plasma |
| 52 | Richtung | | Breakdown erfolgt |
| 60 | Kristallgitterebenen normale | 405 | Energie zur Elektronenerzeugung (zum Großteil transmittiert) |
| 80 | Hauptoberflächennormale | | |
| 406 | I_{ON} Strahlungsintensität im Fokus, bei welcher ein Modifikations-onset erfolgt | 450 | Elektronendichte im Fokus |
| | | 451 | Plasma onset (Lawinendurchbruch; entspricht halber maximaler Elektronendichte) |
| | | | |
| 408 | Pulsstart | | |
| 409 | Multiphotonenprozess-onset | | |
| 410 | tₘₚ Zeit nach Pulsstart bei der Multiphotonenprozess-onset erfolgt | 452 | Elektronenplasma oszilliert mit der Laserstrahlung |
| | | | |
| 412 | Zeit nach Pulsstart bei der Modifikations-onset erfolgt | 453 | Lineare Absorption durch schon vorhandene amorphisierte Kristallgebiete |
| | | | |
| | | | |
| 413 | Modifikations-onset | 5700 | Lichtkegel |
| 414 | Modifikationszeit | 5702 | Fokusabbild |
| 416 | Elektronen Plasma Breakdown I_{BD}<I_{ON} da Absorption BD> Absorption ON | 5703 | Fokusabbild |
| 418 | Mod ifikations-breakdown | R | Längserstreckungsrichtung der Modifikation |
| | | | |
| 420 | Pulsende | | |

## Patentansprüche

1. Verfahren zum Erzeugen von Mikrorissen (9) im Inneren einer Kompositstruktur (83), mindestens umfassend die Schritte:
Bereitstellen oder Erzeugen der Kompositstruktur (83),
wobei die Kompositstruktur (83) einen Festkörper (1) und zumindest eine einerseits des Festkörpers (1) angeordnete oder ausgebildete metallische Beschichtung und/oder elektrische Bauteile (82) aufweist und andererseits eine ebene Oberfläche (8) ausbildet,
wobei der Festkörper (1) Siliziumcarbid (SiC) aufweist oder daraus besteht,
Erzeugen von Modifikationen (9) im Inneren des Festkörpers (1),
wobei Laserstrahlung (14) über die ebene Oberfläche (8) in den Festkörper (1) eingebracht wird, wobei die Laserstrahlung (14) eine Mehrphotonenanregung bewirkt,
**dadurch gekennzeichnet, dass**
die Mehrphotonenanregung eine Plasmaerzeugung bewirkt,
wobei die Modifikation durch das Plasma in Form einer Materialumwandlung bewirkt wird,
wobei die Materialumwandungen Druckspannungen im Festkörper (1) erzeugen,
wobei der Festkörper (1) in einem umliegenden Bereich der jeweiligen Modifikation (9) unterkritisch einreißt,
wobei die Modifikationen (9) in einem Abstand von weniger als 150 µm zur metallischen Beschichtung und/oder den elektrischen Bauteilen (82) erzeugt werden, wobei die Laserstrahlung (14) in Pulsen in den Festkörper (1) eingebracht wird,
wobei die Pulsintensität eines Pulses innerhalb von 10ns ab dem Beginn des jeweiligen Pulses die maximale Pulsintensität erreicht.

2. Verfahren nach Anspruch 1,
**dadurch gekennzeichnet, dass**
jeder Puls eine Energie E in den Festkörper (1) einbringt, wobei durch die Plasmaerzeugung und/oder bereits erzeugte Mikrorisse maximal 20%, insbesondere maximal 15% oder maximal 10% oder maximal 5% oder maximal 1% oder maximal 0,5%, der Energie E des jeweiligen Pulses bis zur metallischen Beschichtung und/oder den elektrischen Bauteilen durch den Festkörper transmittiert wird.

3. Verfahren nach Anspruch 1 oder Anspruch 2,
**dadurch gekennzeichnet, dass**
das Plasma je Puls innerhalb einer Zeit x ab dem Beginn des Pulses erzeugt wird,
wobei x kürzer ist als die Pulsdauer y und wobei x kleiner als 10ns, insbesondere kleiner als 7,5ns oder kleiner als 5ns oder kleiner als 3ns oder kleiner als 2ns oder kleiner als 1ns oder kleiner als 0,75ns oder kleiner als 0,5ns, ist, wobei bevorzugt x<0,5*y, insbesondere x<0,2*y oder x<0,1*y oder x<0,05*y oder x<0,01*y, gilt.

4. Verfahren nach einem der vorangegangenen Ansprüche,
**dadurch gekennzeichnet, dass**
die Strahlqualität (M2) kleiner als 1,4, insbesondere kleiner als 1,3 oder kleiner als 1,2 oder kleiner 1,1, ist.

5. Verfahren nach Anspruch 3,
**dadurch gekennzeichnet, dass**
die Laserstrahlung (14) mit einer Pulsdauer von weniger als 9ns, insbesondere von weniger als 8ns oder weniger als 7ns oder weniger als 6ns oder weniger als 5ns oder weniger als 4ns oder weniger als 3ns oder weniger als 2ns oder weniger als 1,8ns oder weniger als 1,6ns oder weniger als 1,4ns oder weniger als 1,1ns oder weniger als 0,9ns oder weniger als 0,75ns oder weniger als 0,6ns oder weniger als 0,5ns oder weniger als 0,4ns, erzeugt wird.

6. Verfahren nach einem der vorangegangenen Ansprüche,
**dadurch gekennzeichnet, dass**
die Strahlungsintensität eines Pulses nach dem Erreichen des Maximums für eine Mindestdauer von 10ps, insbesondere von mindesten 50ps oder mindestens 100ps oder 500ps oder 1ns, insbesondere zum Erzeugen eines thermischen Prozesses, und einer Maximaldauer von 25ns, insbesondere von 15ns oder 10ns oder 7,5ns oder 5ns oder 3,5ns oder 2,5ns oder 2ns, über 50% der Strahlungsintensität aufweist.

7. Verfahren nach einem der vorangegangenen Ansprüche,
**dadurch gekennzeichnet, dass**
die Laserstrahlung (14) definiert, insbesondere linear, polarisiert ist,
wobei die Polarisationsrichtung der Laserstrahlung in einem definierten Winkel, insbesondere festem Winkel von 0° oder 90°, oder definierten Winkelbereich, insbesondere -20° bis 20° oder -10° bis 10° oder -5° bis 5° oder -1° bis 1° oder 70° bis 110° oder 80° bis 100° oder 85° bis 95° oder 89° bis 91° oder in einem Winkel <30° oder in einem Winkel <20° oder in einem Winkel <15° oder in einem Winkel <10° oder in einem Winkel <5°, gegenüber der Kristallachse des Festkörpers orientiert ist.

8. Verfahren nach einem der vorangegangenen Ansprüche,
**dadurch gekennzeichnet, dass**
die Längserstreckungsrichtung (R) der mittels der Laserstrahlen (14) im Inneren des Festkörpers (1) erzeugten Modifikationen (9) in einem definierten Winkel, insbesondere festem Winkel von 0° oder 90°, oder definierten Winkelbereich, insbesondere -20° bis 20° oder -10° bis 10° oder -5° bis 5° oder - 1° bis 1° oder 70° bis 110° oder 80° bis 100° oder 85° bis 95° oder 89° bis 91°, gegenüber einer sich an der, insbesondere gedachten oder virtuellen, Schnittstelle zwischen einer Ebene auf der die Modifikationen erzeugt werden (Erzeugungsebene) und einer Kristallgitterebene (6) ergebenden, insbesondere virtuellen bzw. gedachten, Schnittlinie (10) ausgerichtet ist.

9. Verfahren nach einem der vorangegangenen Ansprüche,
**dadurch gekennzeichnet, dass**
die Laserstrahlung (14) über mindestens ein optisches Element in den Festkörper (1) eingebracht wird, wobei das optische Element, insbesondere eine Linse, eine Numerische Apertur von mehr als 0,4, insbesondere von mehr als 0,5 oder 0,6 oder 0,7 oder 0,8 oder 0,9, aufweist,
wobei die Laserstrahlung (14) vor dem Eindringen in den Festkörper (1) bevorzugt durch eine Immersionsflüssigkeit, insbesondere eine Immersionslösung, geleitet wird, wobei die NA bei Verwendung einer Immersionsflüssigkeit bevorzugt größer 1, insbesondere größer 1,1 oder 1,2 oder 1,3 und bevorzugt bis zu 2, ist.

10. Verfahren nach einem der vorangegangenen Ansprüche,
**dadurch gekennzeichnet, dass**
die einzelnen Modifikationen (9) eine maximale Erstreckung in Festkörperlängsrichtung (Z) aufweisen, wobei die maximale Erstreckung der Modifikationen (9) bevorzugt jeweils kleiner als 100µm, insbesondere weniger als 80µm oder weniger als 70µm oder weniger als 60µm oder weniger als 50µm oder weniger als 40µm oder weniger als 30µm oder weniger als 20µm oder weniger als 15µm oder weniger als 10µm oder weniger als 8µm oder weniger als 6µm oder weniger als 5µm oder weniger als 4µm oder weniger als 3µm oder weniger als 2µm oder weniger als 1µm oder weniger als 0,5µm, ist

11. Verfahren nach einem der vorangegangenen Ansprüche,
**dadurch gekennzeichnet, dass**
eine Vielzahl an Modifikationen (9) unter Ausbildung einer linienförmigen Gestalt (103) oder mehrerer linienförmiger Gestalten (103), insbesondere einer Schreiblinie oder mehrerer Schreiblinien, erzeugt werden,
wobei die unterkritischen Risse orthogonal zur Längserstreckungsrichtung der jeweiligen linienförmigen Gestalt (103) eine mittlere Risslänge von weniger als 150 µm, insbesondere von weniger als 120 µm oder weniger als 110 µm oder weniger als 90 µm oder weniger als 75 µm oder weniger als 60 µm oder weniger als 50 µm oder weniger als 40 µm oder weniger als 30µm oder weniger als 25µm, aufweisen.

12. Verfahren nach einem der vorangegangenen Ansprüche,
**dadurch gekennzeichnet, dass**
der Abstand zwischen jeweils zwei unmittelbar nebeneinanderliegenden linienförmigen Gestalten (103) weniger als 400µm, insbesondere weniger als 300µm oder weniger als 250µm oder weniger als 200µm oder weniger als 150µm oder weniger als 100µm oder weniger als 75µm oder weniger als 50µm oder weniger als 40µm oder weniger als 30µm oder weniger als 25µm oder weniger als 20µm oder weniger als 15µm oder weniger als 10µm, beträgt.

13. Verfahren nach einem der vorangegangenen Ansprüche,
**dadurch gekennzeichnet, dass**
im Weg der Laserstrahlung (14) vor dem Eindringen der Laserstrahlung (14) in den Festkörper (1) ein diffraktives optisches Element (DOE) angeordnet ist, wobei die Laserstrahlung (14) durch das DOE auf mehrere Lichtpfade zum Erzeugen mehrerer Fokusse aufgeteilt wird,
wobei das DOE bevorzugt über eine Länge von 200µm eine Bildfeldwölbung bewirkt, die kleiner oder gleich 50µm, insbesondere kleiner oder gleich 30µm oder kleiner oder gleich 10µm oder kleiner oder gleich 5 µm oder kleiner oder gleich 3µm, ist, wobei durch das DOE zumindest 2 und bevorzugt mindestens oder genau 3 oder mindestens oder genau 4 oder mindestens oder genau oder mindestens oder genau oder bis zu 5 oder mindestens oder genau oder bis zu 10 oder mindestens oder genau oder bis zu 20 oder mindestens oder genau oder bis zu 50 oder bis zu 100 Fokusse zur Veränderung der Materialeigenschaften des Festkörpers (1) zeitgleich erzeugt werden.

14. Verfahren zum Erzeugen von Modifikationen im Inneren eines Festkörpers (1), das mindestens
die nachfolgend genannten Schritte aufweist:
Einbringen von Laserstrahlung (14) eines Lasers (29) über eine erste Oberfläche (8) des Festkörpers (1) in das Innere des Festkörpers (1),
wobei der Festkörper (1) eine Kristallstruktur ausbildet und bevorzugt aus SiC besteht,
wobei durch die Laserstrahlung (14) Modifikationen (9) an vorbestimmten Stellen auf einer Erzeugungsebene (4) im Inneren des Festkörpers (1) zum Vorgeben einer Ablöseebene erzeugt werden,
**dadurch gekennzeichnet, dass**
die Laserstrahlung (14) je Modifikation (9) das Konditionieren eines Plasmas zum Modifizieren des Festkörpers (1) bewirkt und das Plasma für eine Modifikationserzeugungszeit (414) existent gehalten wird,
wobei ab dem Beginn eines Laserpulses und bis unmittelbar vor der Konditionierung des Plasmas eine Transmissionszeit (403) liegt, in der die Laserstrahlung (14) zumindest teilweise durch den Festkörper (1) hindurch läuft,
wobei die Konditionierung des Plasmas in einer Plasmakonditionierungszeit (412) erfolgt, und in der Plasmakonditionierungszeit (412) das Plasma beaufschlagende Laserstrahlung (14) zumindest mehrheitlich und bevorzugt vollständig vom Plasma absorbiert und/oder reflektiert und/oder gestreut wird,
wobei die Gesamtzeit aus Modifikationserzeugungszeit (414), Transmissionszeit (403) und Plasmakonditionierungszeit (412), insbesondere Zündung und Aufheizung des Plasmas, mindestens 70% einer Pulsdauer der Laserstrahlung (14) während der Erzeugung der Modifikation (9) entspricht, und
wobei die Pulsdauer kleiner ist als 100ns, wobei die Laserstrahlung im Fokuspunkt eine definierte Strahlungsintensität erzeugt, durch die sich eine definierte Elektronendichte ergibt, wobei die Elektronendichte im Fokuspunkt innerhalb der Modifikationserzeugungszeit einen vordefinierten Schwellenwert überschreitet, wobei die Modifikationserzeugungszeit kürzer ist als 70ns.

15. Verfahren zum Abtrennen von mindestens einer Festkörperschicht (2) von einer Kompositstruktur (83)
mindestens umfassend die Schritte:
Durchführen eines Verfahrens gemäß einem der vorangegangenen Ansprüche,
Einleiten einer äußeren Kraft in die Kompositstruktur, insbesondere in den Festkörper (1), zum Erzeugen von Spannungen in dem Festkörper (1) und/oder Erzeugen einer inneren Kraft in dem Festkörper (1), wobei die äußere und/oder innere Kraft so stark ist, dass daraus eine Rissausbreitung bzw. Verbindung der unterkritischen Risse entlang des Ablösebereichs (8) resultiert.

## Claims

1. Method for producing microcracks (9) in the interior of a composite structure (83), at least comprising the steps of:
providing or producing the composite structure (83),
wherein the composite structure (83) has a solid body (1) and at least one metallic coating and/or electrical components (82) arranged or formed on one side of the solid body (1) and on the other side forms a planar surface (8),
wherein the solid body (1) comprises or consists of silicon carbide (SiC),
generating modifications (9) in the interior of the solid body (1),
wherein laser radiation (14) is introduced into the solid body (1) via the planar surface (8), wherein the laser radiation (14) brings about multiphoton excitation,
**characterized in that**
the multiphoton excitation brings about plasma generation,
wherein the modification is brought about by the plasma in the form of a material transformation,
wherein the material transformations generate compressive stresses in the solid body (1),
wherein the solid body (1) develops subcritical cracks in a surrounding area of the respective modification (9),
wherein the modifications (9) are generated at a distance of less than 150 µm from the metallic coating and/or the electrical components (82),
wherein the laser radiation (14) is introduced into the solid body (1) in pulses,
wherein the pulse intensity of the pulses reaches the maximum pulse intensity within 10 ns after the beginning of the respective pulse.

2. Method according to Claim 1,
**characterized in that**
each pulse introduces an energy E into the solid body (1), wherein, as a result of the plasma generation and/or microcracks already produced, a maximum of 20%, in particular a maximum of 15% or a maximum of 10% or a maximum of 5% or a maximum of 1% or a maximum of 0.5%, of the energy E of the respective pulse is transmitted through the solid body up to the metallic coating and/or the electrical components.

3. Method according to Claim 1 or Claim 2, **characterized in that**
the plasma for each pulse is generated within a time x after the beginning of the pulse,
wherein x is shorter than the pulse duration y and wherein x is less than 10 ns, in particular less than 7.5 ns or less than 5 ns or less than 3 ns or less than 2 ns or less than 1 ns or less than 0.75 ns or less than 0.5 ns, wherein preferably x<0.5*y, in particular x<0.2*y or x<0.1*y or x<0.05*y or x<0.01*y.

4. Method according to one of the preceding claims, **characterized in that**
the beam quality (M2) is less than 1.4, in particular less than 1.3 or less than 1.2 or less than 1.1.

5. Method according to Claim 3,
**characterized in that**
the laser radiation (14) is generated with a pulse duration of less than 9 ns, in particular of less than 8 ns or less than 7 ns or less than 6 ns or less than 5 ns or less than 4 ns or less than 3 ns or less than 2 ns or less than 1.8 ns or less than 1.6 ns or less than 1.4 ns or less than 1.1 ns or less than 0.9 ns or less than 0.75 ns or less than 0.6 ns or less than 0.5 ns or less than 0.4 ns.

6. Method according to one of the preceding claims, **characterized in that**
the radiation intensity of a pulse after reaching the maximum has over 50% of the radiation intensity for a minimum duration of 10 ps, in particular of at least 50 ps or at least 100 ps or 500 ps or 1 ns, in particular for producing a thermal process, and a maximum duration of 25 ns, in particular of 15 ns or 10 ns or 7.5 ns or 5 ns or 3.5 ns or 2.5 ns or 2 ns.

7. Method according to one of the preceding claims, **characterized in that**
the laser radiation (14) is polarized in a defined manner, in particular linearly polarized,
wherein the polarization direction of the laser radiation is oriented at a defined angle, in particular a fixed angle of 0° or 90°, or a defined angular range, in particular -20° to 20° or -10° to 10° or -5° to 5° or -1° to 1° or 70° to 110° or 80° to 100° or 85° to 95° or 89° to 91° or at an angle <30° or at an angle <20° or at an angle <15° or at an angle <10° or at an angle <5°, with respect to the crystal axis of the solid body.

8. Method according to one of the preceding claims, **characterized in that**
the direction of longitudinal extent (R) of the modifications (9) generated in the interior of the solid body (1) is oriented at a defined angle, in particular a fixed angle of 0° or 90°, or a defined angular range, in particular -20° to 20° or -10° to 10° or -5° to 5° or -1° to 1° or 70° to 110° or 80° to 100° or 85° to 95° or 89° to 91°, with respect to an, in particular virtual or imaginary, intersection line (10) that results at the, in particular imaginary or virtual, interface between a plane on which the modifications are generated (generation plane) and a crystal lattice plane (6).

9. Method according to one of the preceding claims, **characterized in that**
the laser radiation (14) is introduced into the solid body (1) via at least one optical element, wherein the optical element, in particular a lens, has a numerical aperture of more than 0.4, in particular of more than 0.5 or 0.6 or 0.7 or 0.8 or 0.9,
wherein, prior to penetration into the solid body (1), the laser radiation (14) is preferably directed through an immersion liquid, wherein, when using an immersion liquid, the NA is preferably greater than 1, in particular greater than 1.1 or 1.2 or 1.3 and preferably up to 2.

10. Method according to one of the preceding claims, **characterized in that**
the individual modifications (9) have a maximum extent in the longitudinal direction (Z) of the solid body, wherein the maximum extent of the modifications (9) is preferably in each case less than 100 µm, in particular less than 80 µm or less than 70 µm or less than 60 µm or less than 50 µm or less than 40 µm or less than 30 µm or less than 20 µm or less than 15 µm or less than 10 µm or less than 8 µm or less than 6 µm or less than 5 µm or less than 4 µm or less than 3 µm or less than 2 µm or less than 1 µm or less than 0.5 µm.

11. Method according to one of the preceding claims, **characterized in that**
a multiplicity of modifications (9) are generated to form a linear shape (103) or multiple linear shapes (103), in particular a writing line or multiple writing lines,
wherein the subcritical cracks have orthogonally to the direction of longitudinal extent of the respective linear shape (103) an average crack length of less than 150 µm, in particular of less than 120 µm or less than 110 µm or less than 90 µm or less than 75 µm or less than 60 µm or less than 50 µm or less than 40 µm or less than 30 µm or less than 25 µm.

12. Method according to one of the preceding claims, **characterized in that**
the distance in each case between two directly adjacent linear shapes (103) is less than 400 µm, in particular less than 300 µm or less than 250 µm or less than 200 µm or less than 150 µm or less than 100 µm or less than 75 µm or less than 50 µm or less than 40 µm or less than 30 µm or less than 25 µm or less than 20 µm or less than 15 µm or less than 10 µm.

13. Method according to one of the preceding claims, **characterized in that**
a diffractive optical element (DOE) is arranged in the path of the laser radiation (14) upstream from the penetration of the laser radiation (14) into the solid body, wherein the laser radiation (14) is divided by the DOE over multiple light paths to produce multiple focuses,
wherein the DOE brings about, preferably over a length of 200 µm, an image field curvature that is less than or equal to 50 µm, in particular less than or equal to 30 µm or less than or equal to 10 µm or less than or equal to 5 µm or less than or equal to 3 µm, wherein the DOE simultaneously produces at least 2 and preferably at least or exactly 3 or at least or exactly 4 or at least or exactly or up to 5 or at least or exactly or up to 10 or at least or exactly or up to 20 or at least exactly or up to 50 or up to 100 focuses for changing the material properties of the solid body (1) .

14. Method for generating modifications in the interior of a solid body (1), which has at least the steps mentioned below:
introducing laser radiation (14) of a laser (29) into the interior of the solid body (1) via a first surface (8) of the solid body (1),
wherein the solid body (1) forms a crystal structure and preferably consists of SiC,
wherein modifications (9) are generated by the laser radiation (14) at predetermined locations on a generation plane (4) in the interior of the solid body (1) for defining a detachment plane,
**characterized in that**
for each modification (9), the laser radiation (14) brings about the conditioning of a plasma for modifying the solid body (1) and the plasma is kept in existence for a modification generating time (414), wherein, from the beginning of a laser pulse and up to directly before the conditioning of the plasma, there is a transmission time (403), in which the laser radiation (14) passes at least partially through the solid body (1),
wherein the conditioning of the plasma takes place in a plasma conditioning time (412), and, in the plasma conditioning time (412), laser radiation (14) acting on the plasma is at least mostly and preferably completely absorbed and/or reflected and/or scattered by the plasma,
wherein the overall time comprising the modification generating time (414), the transmission time (403) and the plasma conditioning time (412), in particular igniting and heating up the plasma, corresponds to at least 70% of a pulse duration of the laser radiation (14) during the generation of the modification (9), and wherein the pulse duration is less than 100 ns, wherein the laser radiation produces a defined radiation intensity at the focal point, which results in a defined electron density, wherein the electron density at the focal point exceeds a predefined threshold value within the modification generating time, wherein the modification generating time is shorter than 70 ns.

15. Method for detaching at least one solid body layer (2) from a composite structure (83),
at least comprising the steps of:
carrying out a method according to one of the preceding claims,
introducing an external force into the composite structure, in particular into the solid body (1), for generating stresses in the solid body (1) and/or generating an internal force in the solid body (1), wherein the external and/or internal force is strong enough to result in crack propagation or joining of the subcritical cracks along the detachment area (8).

## Revendications

1. Procédé de production de microfissures (9) à l'intérieur d'une structure (83) composite, comprenant au moins les stades :
on se procure ou on produit la structure (83) composite,
dans lequel la structure (83) composite a un corps (1) solide et au moins un revêtement métallique et/ou des composants (82) électriques disposés ou constitués d'un côté du corps (1) solide et forme de l'autre côté une surface (8) plane,
dans lequel le corps (1) solide a du carbure de silicium (SiC) ou en est constitué,
on produit des modifications (9) à l'intérieur du corps (1) solide,
dans lequel on introduit du rayonnement (14) laser dans le corps (1) solide par la surface (8) plane, le rayonnement (14) laser provoquant une excitation multiphotonique,
**caractérisé en ce que**
l'excitation multiphotonique provoque une production de plasma,
dans lequel la modification par le plasma est provoquée sous la forme d'une transformation de matériau,
dans lequel les transformations de matériau produisent des contraintes de compression dans le corps (1) solide,
dans lequel le corps (1) solide se rompt de manière sous-critique dans une partie environnante de la modification (9) respective,
dans lequel on produit les modifications (9) à une distance de moins de 150 µm du revêtement métallique et/ou des composants (82) électriques,
dans lequel on introduit le rayonnement (14) laser en impulsions dans le corps (1) solide,
dans lequel l'intensité d'une impulsion atteint l'intensité maximum d'impulsion en 10 ns à partir du début de l'impulsion respective.

2. Procédé suivant la revendication 1,
**caractérisé en ce que**
chaque impulsion introduit une énergie E dans le corps (1) solide, dans lequel, par la production de plasma et/ou par des microfissures déjà produites, on transmet à travers le corps solide au maximum 20 %, notamment au maximum 15 % ou au maximum 10 % ou au maximum 5 % ou au maximum 1 % ou au maximum 0,5 % de l'énergie E de l'impulsion respective jusqu'au revêtement métallique et/ou aux composants électriques.

3. Procédé suivant la revendication 1 ou la revendication 2, **caractérisé en ce que**
on produit le plasma par impulsion en un temps x à partir du début de l'impulsion
dans lequel x est plus court que la durée y de l'impulsion et dans lequel x est plus petit que 10 ns, notamment plus petite que 7,5 ns ou plus petit que 5 ns ou plus petit que 3 ns ou plus petit que 2 ns ou plus petit que 1 ns ou plus petit que 0,75 ns ou plus petit que 0,5 ns, dans lequel on a de préférence x < 0,5*y, notamment x < 0,2*y ou x < 0,1*y ou x < 0,05*y ou x < 0,01*y.

4. Procédé suivant l'une des revendications précédentes, **caractérisé en ce que**
la qualité (M2) du rayonnement est plus petite que 1,4, notamment plus petite que 1,3 ou plus petite que 1,2 ou plus petite que 1,1.

5. Procédé suivant la revendication 3,
**caractérisé en ce que**
on produit le rayonnement (14) laser à une durée d'impulsion de moins de 9 ns, notamment de moins de 8 ns ou de moins de 7 ns ou de moins de 6 ns ou de moins de 5 ns ou de moins de 4 ns ou de moins de 3 ns ou de moins de 2 ns ou de moins de 1,8 ns ou de moins de 1,6 ns ou de moins de 1,4 ns ou de moins de 1,1 ns ou de moins de 0,9 ns ou de moins de 0,75 ns ou de moins de 0,6 ns ou de moins de 0,5 ns ou de moins de 0,4 ns.

6. Procédé suivant l'une des revendications précédentes, **caractérisé en ce que**
l'intensité de rayonnement d'une impulsion, après avoir atteint le maximum pendant une durée minimum de 10 ps, notamment d'au moins 50 ps ou d'au moins 100 ps ou 500 ps ou d'1 ns, notamment pour la production d'un processus thermique, et une durée maximum de 25 ns, notamment de 15 ns ou de 10 ns ou de 7,5 ns ou de 5 ns ou de 3,5 ns ou de 2,5 ns ou de 2 ns, représente plus de 50 % de l'intensité du rayonnement.

7. Procédé suivant l'une des revendications précédentes, **caractérisé en ce que**
le rayonnement (14) laser est polarisé de manière définie, notamment linéairement,
dans lequel la direction de polarisation du rayonnement laser est orientée dans un angle défini, notamment dans un angle fixe de 0° ou 90°, ou dans une plage angulaire définie, notamment de -20° à 20° ou de -10° à 10° ou de -5° à 5° ou de -1° à 1° ou de 70° à 110° ou de 80° à 100° ou de 85° à 95° ou de 89° à 91° ou dans un angle < 30° ou dans un angle < 20° ou dans un angle < 15° ou dans un angle < 10° ou dans un angle < 5°, avec l'axe cristallin du corps solide.

8. Procédé suivant l'une des revendications précédentes, **caractérisé en ce que**
la direction (R) d'étendue en longueur des modifications (9) produites à l'intérieur du corps (1) solide au moyen du rayonnement (14) laser est dirigée suivant un angle défini, notamment suivant un angle fixe de 0° ou de 90° ou suivant une plage angulaire définie, notamment de -20° à 20° ou de -10° à 10° ou de -5° à 5° ou de -1° à 1° ou de 70° à 110° ou de 80° à 100° ou de 85° à 95° ou de 89° à 91° avec l'interface, notamment imaginaire ou virtuelle, entre un plan sur lequel les modifications sont produites (plan de production) et une ligne (10) de coupe, notamment virtuelle ou imaginaire, donnant un plan (6) du réseau cristallin.

9. Procédé suivant l'une des revendications précédentes, **caractérisé en ce que**
on introduit le rayonnement (14) laser dans le corps (1) solide par au moins un élément optique, dans lequel l'élément optique, notamment une lentille, a une ouverture numérique de plus de 0,4, notamment de plus de 0,5 ou de 0,6 ou de 0,7 ou de 0,8 ou de 0,9,
dans lequel on envoie le rayonnement (14) laser avant l'introduction dans le corps (1) solide de préférence dans un liquide d'immersion, notamment dans une solution d'immersion, dans lequel l'ouverture numérique, lors de l'utilisation d'un liquide d'immersion, est de préférence plus grande que 1, notamment plus grande que 1,1 ou 1,2 ou 1,3 et de préférence allant jusqu'à 2.

10. Procédé suivant l'une des revendications précédentes, **caractérisé en ce que**
les diverses modifications (9) ont une étendue maximum dans la direction (Z) longitudinale du corps solide, l'étendue maximum des modifications (9) étant chacune de préférence plus petite que 100 µm, notamment plus petite que 80 µm ou plus petite que 70 µm ou plus petite que 60 µm ou plus petite que 50 µm ou plus petite que 40 µm ou plus petite que 30 µm ou plus petite que 20 µm ou plus petite que 15 µm ou plus petite que 10 µm ou plus petite que 8 µm ou plus petite que 6 µm ou plus petite que 5 µm ou plus petite que 4 µm ou plus petite que 3 µm ou plus petite que 2 µm ou plus petite que 1 µm ou plus petite que 0,5 µm.

11. Procédé suivant l'une des revendications précédentes, **caractérisé en ce que**
on produit une pluralité de modifications (9) en constituant une conformation (103) linéaire ou plusieurs conformations (103) linéaires, notamment une ligne de défilement ou plusieurs lignes de défilement,
dans lequel les fissures sous-critiques ont, orthogonalement, à la direction d'étendue en longueur de la conformation (103) linéaire respective, une longueur moyenne de fissure de moins de 150 µm, notamment de moins de 120 µm ou de moins de 110 µm ou de moins de 90 µm ou de moins de 75 µm ou de moins de 60 µm ou de moins de 50 µm ou de moins de 40 µm ou de moins de 30 µm ou de moins de 25 µm.

12. Procédé suivant l'une des revendications précédentes, **caractérisé en ce que**
la distance entre respectivement deux conformations (103) linéaires directement l'une à côté de l'autre est plus petite que 400 µm, notamment plus petite que 300 µm ou plus petite que 250 µm ou plus petite que 200 µm ou plus petite que 150 µm ou plus petite que 100 µm ou plus petite que 75 µm ou plus petite que 50 µm ou plus petite que 40 µm ou plus petite que 30 µm ou plus petite que 25 µm ou plus petite que 20 µm ou plus petite que 15 µm ou plus petite que 10 µm.

13. Procédé suivant l'une des revendications précédentes, **caractérisé en ce que**
dans le trajet du rayonnement (14) laser est monté avant la pénétration du rayonnement (14) laser dans le corps (1) solide, un élément (DOE) optique de diffraction, le rayonnement (14) laser étant subdivisé par le DOE en plusieurs trajets lumineux pour produire plusieurs foyers,
dans lequel le DOE provoque, sur une longueur de 200 µm, une courbure du champ d'image, qui est inférieure ou égale à 50 µm, notamment inférieure ou égale à 30 µm ou inférieure ou égale à 10 µm, ou inférieure ou égale à 5 µm ou inférieure ou égale à 3 µm, dans lequel, par le DOE, au moins 2 et de préférence au moins exactement 3 ou au moins exactement 4 ou au moins exactement jusqu'à 5 ou au moins exactement jusqu'à 10 ou au moins exactement jusqu'à 20 ou au moins exactement jusqu'à 50 ou jusqu'à 100 foyers sont produits en même temps pour modifier les propriétés de matériau du corps (1) solide.

14. Procédé de production de modifications à l'intérieur d'un corps (1) solide, qui a au moins les stades mentionnés dans ce qui suit :
introduction d'un rayonnement (14) laser d'un laser (29) à l'intérieur du corps (1) solide par une première surface (8) du corps (1) solide,
le corps (1) solide formant une structure cristalline et étant de préférence en SiC,
dans lequel on produit par le rayonnement (14) laser des modifications (9) en des endroits déterminés à l'avance sur un plan (4) de production à l'intérieur du corps (1) solide pour prescrire un plan de détachement,
**caractérisé en ce que**
le rayonnement (14) laser provoque par modification (9) le conditionnement d'un plasma pour modifier le corps (1) solide et on maintient le plasma existant pendant une durée (414) de production de modification,
dans lequel à partir du début d'une impulsion laser et jusqu'à immédiatement avant le conditionnement du plasma, s'écoule un temps (403) de transmission, pendant lequel le rayonnement (14) laser passe au moins en partie à travers le corps (1) solide,
dans lequel le conditionnement du plasma s'effectue dans un temps (412) de conditionnement du plasma et, dans le temps (412) de conditionnement du plasma, on absorbe et/ou on réfléchit et/ou on disperse, au moins pour la plus grande partie et de préférence complètement par le plasma, le rayonnement (14) laser auquel le plasma est soumis,
dans lequel le temps total composé du temps (414) de production d'une modification, du temps (403) de transmission et du temps (412) de conditionnement du plasma, notamment l'amorçage et le chauffage du plasma, représente au moins 70 % d'une durée d'impulsion du rayonnement (14) du laser pendant la production de la modification (9) et
dans lequel la durée de l'impulsion est plus petite que 100 ns, le rayonnement laser produisant au point focal une intensité définie du rayonnement, par laquelle on obtient une densité d'électrons définie, dans lequel la densité d'électrons au point focal, dans le temps de production d'une modification, dépasse une valeur de seuil définie à l'avance, le temps de production d'une modification étant plus court que 70 ns.

15. Procédé de séparation d'au moins une couche (2) de corps solide d'une structure (83) composite,
comprenant au moins les stades :
on effectue un procédé suivant l'une des revendications précédentes,
on applique une force extérieure à la structure composite, notamment dans le corps (1) solide, pour produire des contraintes dans le corps (1) solide et/ou pour produire une force intérieure dans le corps (1) solide, la force extérieure et/ou intérieure étant si intense, qu'il s'ensuite une propagation ou une liaison des fissures sous-critiques dans la partie (8) de détachement.
